(19) Europäisches Patentamt
European Patent Office
Office européen des brevets

(11) **EP 4 335 896 A1**

(12) **EUROPEAN PATENT APPLICATION**

(43) Date of publication:
**13.03.2024 Bulletin 2024/11**

(21) Application number: **23192776.5**

(22) Date of filing: **22.08.2023**

(51) International Patent Classification (IPC):
**C08K 3/30** (2006.01)     **C08K 5/00** (2006.01)
**C08K 5/19** (2006.01)     **C08K 5/20** (2006.01)
**C08L 27/16** (2006.01)     **H10N 30/857** (2023.01)

(52) Cooperative Patent Classification (CPC):
(C-Sets available)
**C08K 5/0083; C08J 5/18; C08K 3/30; C08K 5/19;
C08K 5/20; C08L 27/16; H10N 30/857;**
C08K 2003/3045; C08L 2205/025          (Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **09.09.2022   US 202263405349 P
27.02.2023   US 202318174920**

(71) Applicant: **Meta Platforms Technologies, LLC
Menlo Park, CA 94025 (US)**

(72) Inventors:
 • **LIAO, Christopher Yuan Ting
 Menlo Park (US)**
 • **YE, Sheng
 Menlo Park (US)**

 • **OUDERKIRK, Andrew John
 Menlo Park (US)**
 • **MEI, Hao
 Menlo Park (US)**
 • **JIAN, Rui
 Menlo Park (US)**
 • **YANG, Jinghui
 Menlo Park (US)**
 • **KEENER, Alexander Jacob
 Menlo Park (US)**
 • **HSIEH, Stephen
 Menlo Park (US)**
 • **PETERSON, Jonathan Robert
 Menlo Park (US)**

(74) Representative: **Murgitroyd & Company
165-169 Scotland Street
Glasgow G5 8PL (GB)**

(54) **OPTICAL QUALITY PVDF HAVING ENHANCED PIEZOELECTRIC RESPONSE**

(57)     A mechanically and piezoelectrically anisotropic polymer article is formed from a crystallizable fluoropolymer and a nucleating agent. The polymer article may be a thin film or a fiber, for example. A crystalline phase may constitute at least approximately 50% of the polymer article. In certain examples, a fluoropolymer may include vinylidene fluoride, trifluoroethylene, chlorotrifluoroethylene, hexafluoropropylene, and vinyl fluoride. The polymer article may include up to approximately 10 wt.% of the nucleating agent. Such a polymer article is optically transparent, has an elastic modulus of at least approximately 3 GPa, and an electromechanical coupling factor ($k_{31}$) of at least approximately 0.15.

Melt Process:
PVDF Melt → Extrusion → Stretching → Poling → PVDF film

Solvent Process:
PVDF Solution → Casting → Solvent Removal → Stretching → Poling → PVDF film

*FIG. 1*

EP 4 335 896 A1

(52) Cooperative Patent Classification (CPC): (Cont.)

C-Sets
**C08K 5/0083, C08L 27/12;**
**C08K 5/20, C08L 27/12;**
**C08L 27/16, C08K 3/30, C08L 27/16;**
**C08L 27/16, C08K 5/19, C08L 27/16**

**Description**

**TECHNICAL FIELD**

The instant disclosure is directed generally to optical quality polymer thin films having a high piezoelectric response and their methods of manufacture, and more specifically to the manufacture of optical grade PVDF-based polymer materials having high piezoelectric performance using a specific group of nucleating agents.

**BACKGROUND**

Polymer materials may be incorporated into a variety of different optic and electro-optic systems, including active and passive optics and electroactive devices. Lightweight and conformable, one or more polymer layers may be incorporated into wearable devices such as smart glasses and are attractive candidates for emerging technologies including virtual reality/augmented reality devices where a comfortable, adjustable form factor is desired.

Virtual reality (VR) and augmented reality (AR) eyewear devices and headsets, for instance, may enable users to experience events, such as interactions with people in a computer-generated simulation of a three-dimensional world or viewing data superimposed on a real-world view. By way of example, superimposing information onto a field of view may be achieved through an optical head-mounted display (OHMD) or by using embedded wireless glasses with a transparent heads-up display (HUD) or augmented reality (AR) overlay. VR/AR eyewear devices and headsets may be used for a variety of purposes. Governments may use such devices for military training, medical professionals may use such devices to simulate surgery, and engineers may use such devices as design visualization aids. These and other applications may leverage one or more characteristics of polymer materials, including the refractive index to manipulate light, thermal conductivity to manage heat, and mechanical strength and toughness to provide lightweight structural support.

Notwithstanding recent developments, it would be advantageous to provide optical quality, mechanically robust, and mechanically and piezoelectrically anisotropic polymer thin films that may be incorporated into various optical systems including display systems for artificial reality applications.

**SUMMARY**

According to a first aspect, there is provided a polymer article, comprising: a crystalline fluoropolymer; and a nucleating agent, wherein the polymer article has an elastic modulus of at least approximately 3 GPa and an electromechanical coupling factor ($k_{31}$) of at least approximately 0.15.

The polymer article may comprise a thin film or a fiber.

The crystalline fluoropolymer may comprise a monomodal molecular weight distribution.

The crystalline fluoropolymer may comprise a bimodal molecular weight distribution.

The crystalline fluoropolymer may comprise a moiety selected from the group consisting of vinylidene fluoride, trifluoroethylene, chlorotrifluoroethylene, hexafluoropropylene, vinyl fluoride, homopolymers thereof, co-polymers thereof, and tri-polymers thereof.

The nucleating agent may comprise less than approximately 10 wt.% of the polymer article.

The nucleating agent may comprise tetrabutylammonium hydrogen sulfate, 1-N,3-N,5-N-tris(3-methylbutan-2-yl)benzene-1,3,5-tricarboxamide, or 1,3,5-triaminobenzene: N-[3,5-bis(2,2-dimethylpropanoylamino)phenyl]-2,2-dimethylpropanamide.

The polymer article may be optically clear and comprise less than approximately 10% bulk haze.

The polymer article may comprise a color coordinate ($|b^*|$) of less than approximately 10 for a thickness of less than approximately 300 micrometers.

The polymer article may comprise a piezoelectric strain coefficient $d_{31}$ of at least approximately 10 pC/N.

The polymer article may further comprise an inorganic additive.

The polymer article may have bulk haze of less than approximately 3% over a thickness of approximately 40 micrometers.

The polymer article may have a transmissivity of at least approximately 80% across the visible spectrum.

According to a second aspect, there is provided a method comprising: combining a crystallizable fluoropolymer and a nucleating agent to form a mixture; and forming the mixture into a polymer article, wherein the polymer article has an elastic modulus of at least approximately 3 GPa and an electromechanical coupling factor ($k_{31}$) of at least approximately 0.15.

Forming the mixture into a polymer article may comprise extruding the mixture or forming the mixture into a solution or a gel and casting the solution or the gel.

The method may further comprise applying a stress to the polymer article in an amount sufficient to re-orient crystals or align polymer chains within the polymer article.

The method may further comprise applying an electric field to the polymer article.

The method may further comprise annealing the polymer article.

The polymer article may comprise a fiber and the method may further comprise forming the fiber into a thin film using a process selected from the group consisting of weaving, knitting, and cross-linking.

**BRIEF DESCRIPTION OF THE DRAWINGS**

The accompanying drawings illustrate a number of examples and are a part of the specification. Together with the following description, these drawings demonstrate and explain various principles of the present disclosure.

FIG. 1 is a flow chart of example methods for forming an optical grade PVDF polymer thin film having high electromechanical efficiency according to various embodiments.

FIG. 2 is a plot showing the bimodal distribution of molecular weights among components of an example polymer composition according to some embodiments.

FIG. 3 is a plot showing the bimodal distribution of molecular weights among components of an example polymer composition according to further embodiments.

FIG. 4 is a plot showing the bimodal distribution of molecular weights among components of an example polymer composition according to still further embodiments.

FIG. 5 shows the composition, structure, and melting point of example nucleating agents having a partial positive surface charge according to some embodiments.

FIG. 6 shows the composition, structure, and melting point of example nucleating agents having a partial negative surface charge according to some embodiments.

FIG. 7 shows the composition, structure, and melting point of example nucleating agents having a neutral surface charge according to some embodiments.

FIG. 8 shows the composition, structure, and melting point of example nucleating agents based on a benzene-tricarboxamide according to certain embodiments.

FIG. 9 shows the composition, structure, and melting point of example nucleating agents based on a benzene-tricarboxamide according to further embodiments.

FIG. 10 shows the composition, structure, and melting point of example nucleating agents based on a triaminobenzene according to certain embodiments.

FIG. 11 shows the composition, structure, and melting point of example nucleating agents based on a triaminobenzene according to further embodiments.

FIG. 12 is a schematic view of an example thin film orientation system for manufacturing an optical grade polymer thin film according to some embodiments.

FIG. 13 is a schematic view of a thin film orientation system for manufacturing an optical grade polymer thin film according to further embodiments.

FIG. 14 illustrates a roll-to-roll manufacturing configuration for conveying and orienting a polymer thin film according to certain embodiments.

FIG. 15 illustrates an embodiment of a calendering method for manufacturing a polymer thin film.

FIG. 16 is a schematic illustration of an example color space for characterizing an optical grade polymer according to various embodiments.

FIG. 17 is a table summarizing optical and mechanical properties of example PVDF thin films as a function of nucleating agent content according to some embodiments.

FIG. 18 is an illustration of exemplary augmented-reality glasses that may be used in connection with embodiments of this disclosure.

FIG. 19 is an illustration of an exemplary virtual-reality headset that may be used in connection with embodiments of this disclosure.

Throughout the drawings, identical reference characters and descriptions indicate similar, but not necessarily identical, elements. While the exemplary embodiments described herein are susceptible to various modifications and alternative forms, specific embodiments have been shown by way of example in the drawings and will be described in detail herein. However, the exemplary embodiments described herein are not intended to be limited to the particular forms disclosed. Rather, the present disclosure covers all modifications, equivalents, and alternatives falling within the scope of the appended claims.

**DETAILED DESCRIPTION**

According to some embodiments, suitably oriented piezoelectric polymer thin films may be implemented as an actuatable lens substrate in an optical element such as a liquid lens. Uniaxially-oriented polyvinylidene fluoride (PVDF) thin films, for example, may be used to generate an advantageously anisotropic strain map across the field of view of a lens. However, a low piezoelectric response and/or lack of sufficient optical quality in comparative polyvinylidene fluoride (PVDF) thin films may impede their implementation as an actuatable layer.

The refractive index and piezoelectric response of a polymer thin film may be determined by its chemical composition, the chemical structure of the polymer repeat unit, its density and extent of beta phase crystallinity, as well as the alignment of the beta phase crystals and/or polymer chains. Among these factors, the beta phase crystal or polymer chain alignment may dominate. In crystalline or semi-crystalline polymer thin films, the piezoelectric response may be correlated to the degree or extent of beta phase crystal orientation, whereas the degree or extent of chain entanglement may create comparable piezoelectric response in amorphous polymer thin films.

An applied stress may be used to create a preferred alignment of beta crystals or polymer chains within a polymer thin film and induce a corresponding modification of the refractive index and piezoelectric response along different directions of the film. As disclosed further herein, during processing where a polymer thin film or fiber is stretched to induce a preferred alignment of beta crystals and polymer chains and an attendant modification of the refractive index and piezoelectric response, Applicants have shown that one approach to forming an anisotropic material is to modify the chemical composition of the polymer being stretched.

In accordance with particular embodiments, Applicants have developed polymer thin film manufacturing methods for forming an optical quality PVDF-based polymer thin film having an enhanced piezoelectric response. Whereas in PVDF and related polymers, the total extent of crystallization as well as the alignment of crystals may be limited, e.g., during extrusion, due to polymer chain entanglement, as disclosed herein, and without wishing to be bound by theory, the extrusion or casting of a composition including a nucleating agent may promote the formation of beta phase PVDF and inhibit the formation of microcavities during stretching/alignment, which may lead to improvements in the piezoelectric response a polymer thin film as well as its optical quality.

A PVDF-based polymer thin film may be formed by applying a desired stress state to a crystallizable polymer thin film. A polymer composition capable of crystallizing may be formed into a single layer using appropriate extrusion or casting operations. For example, a vinylidene fluoride-containing composition may be extruded and oriented as a single layer to form a mechanically and piezoelectrically anisotropic thin film. According to further embodiments, a crystallizable polymer may be co-extruded with other polymer materials that are either crystallizable, or those that remain amorphous after orientation, to form a multilayer thin film.

As used herein, the terms "polymer thin film" and "polymer layer" may be used interchangeably. Furthermore, reference to a "polymer thin film" or a "polymer layer" may include reference to a "multilayer polymer thin film" and the like, unless the context clearly indicates otherwise.

In accordance with various embodiments, a polymer composition used to form an anisotropic polymer thin film may include a crystallizable polymer and a nucleating agent. Without wishing to be bound by theory, a nucleating agent may interact with a crystallizable polymer throughout extrusion/casting and stretch processes to expedite the crystallization process, promote the formation of beta phase crystals, and create a uniform crystal size within the polymer thin film, and in some examples, inhibit the formation of microcavities that may compromise optical properties. A composition having a crystallizable polymer and a nucleating agent may be extruded or cast to form a thin film, which may be stretched to induce mechanical and piezoelectric anisotropy through beta phase crystal and/or chain realignment. Stretching may include the application of a uniaxial stress or a biaxial stress. In some embodiments, the application of an in-plane biaxial stress may be performed simultaneously or sequentially.

Example crystallizable polymers may include moieties such as vinylidene fluoride (VDF), trifluoroethylene (TrFE), chlorotrifluoroethylene (CTFE), hexafluoropropylene (HFP), and vinyl fluoride (VF). As used herein, one or more of the foregoing "PVDF-family" moieties may be combined with a nucleating agent and processed to form an anisotropic polymer thin film or fiber.

According to some embodiments, the PVDF-family component of a polymer article may have a monomodal molecular weight distribution (i.e., "high molecular weight") of at least approximately 100,000 g/mol, e.g., at least 100,000 g/mol, at least 150,000 g/mol, at least 200,000 g/mol, at least 250,000 g/mol, at least 300,000 g/mol, at least 350,000 g/mol, at least 400,000 g/mol, at least 450,000 g/mol, or at least 500,000 g/mol, including ranges between any of the foregoing values. According to further embodiments, the PVDF-family component of a polymer article may have a bimodal molecular weight distribution that includes a high molecular weight component and a "low molecular weight" component having a molecular weight of less than approximately 200,000 g/mol, e.g., less than 200,000 g/mol, less than 100,000 g/mol, less than 50,000 g/mol, less than 10,000 g/mol, less than 7,500 g/mol, less than 5,000 g/mol, less than 2,500 g/mol, less than 2,000 g/mol, or less than 1,000 g/mol, including ranges between any of the foregoing values. Use herein of the term "molecular weight" may, in some examples, refer to a weight average molecular weight.

In some embodiments, a polymer composition having a bimodal molecular weight distribution may be stretched to a larger stretch ratio than a comparative polymer (i.e., lacking a low molecular weight component). In some examples, a stretch ratio may be greater than 4, e.g., 5, 10, 20, or more. The act of stretching may include a single stretching step or plural (i.e., successive) stretching steps where one or more of a stretching temperature and a strain rate may be independently controlled.

According to some embodiments, a nucleating agent may be adapted to control the crystalline phase and the crystal size of a crystallizable polymer, which may facilitate a balanced distribution of stresses during stretching/alignment and inhibit the formation of microcavities, particularly at greater stretch ratios. A nucleating agent may promote the formation of beta phase crystals in PVDF-family polymers, for example.

According to some embodiments, the crystalline content of a polymer article may include crystals of poly(vinylidene fluoride), poly(trifluoroethylene), poly(chlorotrifluoroethylene), poly(hexafluoropropylene), and/or poly(vinyl fluoride), for example, although further crystalline polymer materials are contemplated, where a crystalline phase (e.g., beta phase) in a "crystalline" or "semi-crystalline" polymer article may, in some examples, constitute at least approximately 20% of the polymer matrix, e.g., 20, 40, 60, 65, 70, or 80% of the polymer matrix, including ranges between any of the foregoing values.

In accordance with various embodiments, example nucleating agents include positive surface charge, negative surface charge, and neutral surface charge nucleating agents. An example positive surface charge nucleating agent is tetrabutylammonium hydrogen sulfate. A polymer article and a composition used to form the polymer article may each include up to approximately 10 wt.% of a nucleating agent, e.g., less than 10 wt.%, less than 5 wt.%, less than 1 wt.%, less than 0.5 wt.%, less than 0.25 wt.%, or less than 0.1 wt.%, including ranges between any of the foregoing values.

In some examples, the polymer article (and the composition from which it is derived) may include an inorganic additive. An inorganic additive may be incorporated into a method of forming the polymer article and may be increase the polymer article's piezoelectric performance. Example inorganic additives may include nanoparticles (e.g., ceramic nanoparticles such as PZT, BNT, $BaTiO_3$, calcium fluoride, or quartz; or metal or metal oxide nanoparticles), ferrite nanocomposites (e.g., $Fe_2O_3$-$CoFe_2O_4$), and hydrated salts or metal halides, such as LiCl, $Al(NO_3)_3$-$9H_2O$, $BiCl_3$, Ce or Y nitrate hexahydrate, or Mg chlorate hexahydrate. The amount of an inorganic additive may range from approximately 0.001 to 5 wt.% of the polymer article.

In further embodiments, a polymer article may include oligomers and polymers that may have polar interactions with PVDF-family member chains. Such oligomeric and polymeric additives may be incorporated into a mixture that is extruded or cast, for example, and may include ester, ether, hydroxyl, phosphate, fluorine, halogen, or nitrile groups. Particular examples include polymethylmethacrylate, polyethylene glycol, and polyvinyl acetate.

Example methods of forming a polymer article may include extrusion and casting processes to create a desired form factor, and subsequent stretching to align crystallites and/or polymer chains along a predetermined direction.

For instance, a polymer thin film may be formed by solvent casting from a polymer solution. A polymer solution may include one or more crystallizable polymers, one or more nucleating agents, and one or more liquid solvents. Solvent casting, which may provide control of one or more of the polymer composition and concentration, choice and concentration of liquid solvent, and casting temperature, for example, may facilitate decreased entanglement of polymer chains and allow the polymer film to achieve a higher stretch ratio during a later deformation step. A polymer film may be obtained from the polymer solution by evaporating the solvent. The polymer film may be transparent, translucent, or opaque.

The choice of liquid solvent may affect the maximum crystallinity and percent beta phase content of a PVDF-based polymer thin film. In addition, the polarity of the solvent may impact the critical polymer concentration (c*) for polymer chains to entangle in solution. The liquid solvent (i.e., "solvent") may include a single solvent composition or a mixture of different solvents. In some embodiments, the solubility of the crystallizable polymer in the liquid solvent may be at least approximately 0.1 g/100 g (e.g., 1 g/100 g or 10 g/100 g) at a temperature of 25°C or more (e.g., 50°C, 75°C, 100°C, or 150°C).

Example liquid solvents include, but are not limited to, dimethylformamide (DMF), cyclohexanone, dimethylacetamide (DMAc), diacetone alcohol, di-isobutyl ketone, tetramethyl urea, ethyl acetoacetate, dimethyl sulfoxide (DMSO), trimethyl phosphate, N-methyl-2-pyrrolidone (NMP), butyrolactone, isophorone, triethyl phosphate, carbitol acetate, propylene carbonate, glyceryl triacetate, dimethyl phthalate, acetone, tetrahydrofuran (THF), methyl ethyl ketone, methyl isobutyl ketone, glycol ethers, glycol ether esters, and N-butyl acetate.

In some cases, a polymer gel may be obtained from the polymer solution by evaporating the solvent, cooling the polymer solution, adding a relatively poor solvent to the polymer solution, or a combination thereof. The solubility of the crystalline polymer in a poor solvent may be less than 20 g/100 g, e.g., 5 g/100 g or 1 g/100 g at a temperature of less than approximately 150°C, e.g., 75°C, 25°C, 0°C, -40°C, or -70°C. The polymer gel, which includes a mixture of the crystallizable polymer and the liquid solvent, may be transparent, translucent, or opaque.

A PVDF thin film can be oriented either uniaxially or biaxially as a single layer or multilayer to form a piezoelectrically anisotropic thin film. An anisotropic polymer thin film may be formed using a thin film orientation system configured to heat and stretch a polymer thin film in at least one in-plane direction in one or more distinct regions thereof. In some embodiments, a thin film orientation system may be configured to stretch a polymer thin film, i.e., a crystallizable polymer-containing thin film, along only one in-plane direction. For instance, a thin film orientation system may be configured to apply an in-plane stress to a polymer thin film along the x-direction while allowing the thin film to relax along an orthogonal in-plane direction (i.e., along the y-direction). As used herein, the relaxation of a polymer thin film may, in certain examples, accompany the absence of an applied stress along a relaxation direction.

According to some embodiments, within an example system, a polymer thin film may be heated and stretched transversely to a direction of film travel through the system. In such embodiments, a polymer thin film may be held along opposing edges by plural movable clips slidably disposed along a diverging track system such that the polymer thin film is stretched in a transverse direction (TD) as it moves along a machine direction (MD) through heating and deformation zones of the thin film orientation system. In some embodiments, the stretching rate in the transverse direction and the relaxation rate in the machine direction may be independently and locally controlled. In certain embodiments, large scale production may be enabled, for example, using a roll-to-roll manufacturing platform.

In certain aspects, the tensile stress may be applied uniformly or non-uniformly along a lengthwise or widthwise dimension of the polymer thin film. Heating of the polymer thin film may accompany the application of the tensile stress. For instance, a semi-crystalline polymer thin film may be heated to a temperature greater than room temperature (~23°C) to facilitate deformation of the thin film and the formation and realignment of crystals and/or polymer chains therein.

The temperature of the polymer thin film may be maintained at a desired value or within a desired range before, during and/or after the act of stretching, i.e., within a pre-heating zone or a deformation zone downstream of the pre-heating zone, in order to improve the deformability of the polymer thin film relative to an un-heated polymer thin film. The temperature of the polymer thin film within a deformation zone may be less than, equal to, or greater than the temperature of the polymer thin film within a pre-heating zone. The temperature within a deformation zone may be greater than approximately 60°C, i.e., greater than 80°C, great than 100°C, greater than 120°C, greater than 140°C, greater than 160°C, or greater than 180°C.

In some embodiments, the polymer thin film may be heated to a constant temperature throughout the act of stretching. In some embodiments, a region of the polymer thin film may be heated to different temperatures, i.e., during and/or subsequent to the application of the tensile stress. In some embodiments, different regions of the polymer thin film may be heated to different temperatures. In certain embodiments, the strain realized in response to the applied tensile stress may be at least approximately 20%, e.g., approximately 20%, approximately 50%, approximately 100%, approximately 200%, approximately 400%, approximately 500%, approximately 750%, approximately 1000%, approximately 2000%, or more, including ranges between any of the foregoing values.

In some embodiments, the stretched polymer thin film may be annealed at a temperature greater than approximately 60°C, i.e., greater than 80°C, great than 100°C, greater than 120°C, greater than 140°C, or greater than 160°C. Annealing may be conducted under constant strain or constant stress.

In some embodiments, the crystalline content within the polymer thin film may increase during the act of stretching. In some embodiments, stretching may alter the orientation of crystals within a polymer thin film without substantially changing the crystalline content.

Following deformation and orientation of the polymer thin film, the heating may be maintained for a predetermined amount of time, followed by cooling of the polymer thin film. The act of cooling may include allowing the polymer thin film to cool naturally, at a set cooling rate, or by quenching, such as by purging with a low temperature gas, which may thermally stabilize the polymer thin film.

Stretching a PVDF-family film may form both alfa and beta phase crystals, although only aligned beta phase crystals contribute to piezoelectric response. During and/or after a stretching process, an electric field may be applied to the polymer thin film. The application of an electric field (i.e., poling) may induce the formation and alignment of beta phase crystals. Whereas a lower electric field can be applied to align beta phase crystals, a higher electric field can be applied to both induce a phase transformation from the alpha phase to the beta phase and encourage alignment of the beta phase crystals. High piezoelectric performance may be associated with the creation and alignment of beta phase crystals in PVDF-family polymers. Example poling times may range from approximately 1 min to approximately 180 min. During poling, a PVDF fiber may be heated to a temperature of from approximately 20°C to approximately 5°C below the Curie temperature of the polymer.

In example methods, a polymer thin film may be heated during stretching to a temperature of from approximately 60°C to approximately 190°C and stretched at a strain rate of from approximately 0.1%/sec to 300%/sec. Moreover, one or both of the temperature and the strain rate may be held constant or varied during the act of stretching. For instance, a polymer thin film may be stretched at a first temperature and a first strain rate (e.g., 130°C and 50%/sec) to achieve a first stretch ratio. Subsequently, the temperature of the polymer thin film may be increased, and the strain rate may be decreased, to a second temperature and a second strain rate (e.g., 165°C and 5%/sec) to achieve a second stretch ratio.

Such a stretched polymer thin film may exhibit higher crystallinity and a higher elastic modulus. By way of example, an oriented polymer thin film having a bimodal molecular weight distribution may have an elastic modulus greater than approximately 3 GPa, e.g., 4 GPa, 5 GPa, 10 GPa, 15 GPa or 20 GPa, including ranges between any of the foregoing values, and a piezoelectric coefficient ($d_{31}$) greater than approximately 10 pC/N, e.g., 10 pC/N, 20 pC/N, 30 pC/N, or 40 pC/N, including ranges between any of the foregoing values.

Further to the foregoing, an electromechanical coupling factor $k_{ij}$ may indicate the effectiveness with which a piezoelectric material can convert electrical energy into mechanical energy, or vice versa. For a polymer thin film, the electromechanical coupling factor $k_{31}$ may

$$k_{31} = \frac{d_{31}}{\sqrt{e_{33} * s_{31}}}$$

be expressed as , where $d_{31}$ is the piezoelectric strain coefficient, $e_{33}$ is the dielectric permittivity in the thickness direction, and $s_{31}$ is the compliance in the machine direction. Higher values of $k_{31}$ may be achieved by disentangling polymer chains prior to or during stretching and promoting dipole moment alignment within a crystalline phase. In some embodiments, a polymer thin film may be characterized by an electromechanical coupling factor $k_{31}$ of at least approximately 0.15, e.g., 0.15, 0.2, 0.3, or more, including ranges between any of the foregoing values.

A polymer composition including a crystallizable polymer (e.g., a polymer composition having a monomodal or bimodal molecular weight) and a nucleating agent may be formed into a single layer using extrusion or casting operations. Alternatively, such a polymer composition may be co-extruded with other polymers or other non-polymer materials to form a multilayer polymer thin film. The application of a uniaxial or biaxial stress to an extruded single or multilayer thin film may be used to align polymer chains and/or re-orient crystals to induce mechanical and piezoelectric anisotropy therein.

Furthermore, the magnitude of an applied stress during the act of stretching/orienting may influence the formation of the beta phase, where higher stresses may advantageously contribute to the formation of a greater beta phase content. In some examples, the magnitude of an applied stress during stretching/orienting of a polymer article may be at least approximately 50 MPa, e.g., 50 MPa, 100 MPa, 150 MPa, 200 MPa, or 250 MPa, including ranges between any of the foregoing values.

In some embodiments, following stretching, a polymer thin film may be annealed. Annealing may be performed at a fixed or variable stretch ratio and/or a fixed or variable applied stress. An example annealing temperature may be greater than approximately 60°C, e.g., 80°C, 100°C, 120°C, 130°C, 140°C, 150°C, 160°C, 170°C, 180°C, or 190°C, including ranges between any of the foregoing values. The annealing temperature may be constant or may be variable (e.g., increasing) throughout an annealing step. The annealing process may include a single annealing step (e.g., a single temperature) or multiple steps (e.g., at multiple temperatures). In some examples, an annealing process may be performed under a constant applied stress. Annealing may be performed at constant or variable stress or at constant or variable strain. Without wishing to be bound by theory, annealing may stabilize the orientation of polymer chains and decrease the propensity for shrinkage of a polymer thin film or fiber.

Following deformation, the crystals or chains may be at least partially aligned with the direction of the applied tensile stress. As such, a polymer thin film may exhibit a high degree of birefringence, a high degree of optical clarity, bulk haze of less than approximately 10%, a high piezoelectric coefficient, e.g., $d_{31}$ greater than approximately 10 pC/N and/or a high electromechanical coupling factor, e.g., $k_{31}$ greater than approximately 0.15.

According to various embodiments, a method of forming a PVDF fiber may include gel spinning. Gel spinning refers to a technique where a polymer gel is extruded through a spinneret nozzle to form a polymer fiber. In an example method, a solvent bath located downstream of the spinneret nozzle and containing a poor solvent may be used to precipitate the fiber. Exemplary dispense rates of the polymer gel through the nozzle, which may be determined based on the rheological properties of the gel, may range from approximately 0.1 to 10 mL/hr. Suitable poor solvents for PVDF may include THF, cyclohexanone, acetone, and the like. The solvent temperature within the solvent bath may be less than approximately 50°C, e.g., less than 50°C, less than 40°C, less than 30°C, less than 20°C, or less than 10°C, including ranges between any of the foregoing values.

According to various embodiments, a method of forming a PVDF fiber may include melt spinning. Melt spinning refers to a technique where a polymer melt is extruded through a spinneret nozzle to form a polymer fiber. The spun fibers are cooled and collected. Exemplary dispense rates of the polymer melt through the nozzle, which may be determined based on the rheological properties of the gel, may range from approximately 0.1 to 10 mL/hr.

In an electro-spinning method, a PVDF gel may be dispensed through a spinneret nozzle. Example dispense rates may range from approximately 0.1 to 10 mL/hr. During electro-spinning, a first voltage may be applied to the spinneret nozzle and an opposite voltage may be applied to a collection roller located proximate to the nozzle. The magnitude of the voltages may be independently set. An absolute value of the applied voltages may range from approximately 5 to approximately 100 kV.

In some examples, a spun PVDF polymer fiber may be stretched under a constant stress of at least approximately 100 MPa, e.g., 100, 150, 200, 250, or 300 MPa, including ranges between any of the foregoing values. In some examples, a fiber stretch ratio may be greater than approximately 8, e.g., 8, 10, 15, 20, 30, or more, where a strain rate may range from approximately 0.1 %/sec to approximately 300%/sec. The act of stretching may include a single stretching step or plural (i.e., successive) stretching steps where one or more of a stretching temperature and a strain rate may be independently controlled.

In some embodiments, the crystalline content within the polymer fiber may increase during the act of stretching. In some embodiments, stretching may alter the orientation of crystals within a polymer fiber without substantially changing the crystalline content.

Polymer fibers may be annealed during and/or after orientation. Annealing may be performed at a fixed or variable stretch ratio and/or a fixed or variable applied stress. In some embodiments, a polymer fiber may be annealed while under an applied real stress of at least approximately 100 MPa, e.g., 100, 150, 200, 250, or 300 MPa, including ranges between any of the foregoing values. An annealing temperature may be fixed or variable. A variable annealing temperature, for instance, may increase from an initial annealing temperature to a final annealing temperature. The annealing temperature may be greater than the polymer's glass transition temperature ($T_g$) and, in certain examples, may be less than, substantially equal to, or greater than the temperature corresponding to the onset of melting for the polymer.

An example annealing temperature may be greater than approximately 80°C, e.g., 100°C, 120°C, 140°C, 160°C, or 180°C, including ranges between any of the foregoing values. In embodiments where annealing accompanies orienting, one or both of the temperature and the strain rate may be held constant or varied. For instance, a polymer fiber may be stretched at a first temperature and a first strain rate (e.g., 130°C and 50%/sec) to achieve a first stretch ratio. Subsequently, the temperature of the polymer fiber may be increased, and the strain rate may be decreased to a second temperature and a second strain rate (e.g., 165°C and 5%/sec) to achieve a second stretch ratio. Annealing may stabilize the orientation of polymer chains and decrease the propensity for shrinkage of the polymer fiber.

Following orienting of the polymer fiber, the heating may be maintained for a predetermined amount of time, followed by cooling of the fiber. The act of cooling may include allowing the polymer fiber to cool naturally, at a set cooling rate, or by quenching, such as by purging with a low temperature gas, which may thermally stabilize the polymer fiber.

Stretching a PVDF-family fiber may form both alpha and beta phase crystals, although only aligned beta phase crystals contribute to piezoelectric response. During and/or after a stretching process, an electric field may be applied to the polymer fiber. The application of an electric field (i.e., poling) may induce the formation and alignment of beta phase crystals. Whereas a lower electric field may be applied to align beta phase crystals, a higher electric field may be applied to both induce a phase transformation from the alpha phase to the beta phase and encourage alignment of the beta phase crystals.

A corona poling method may be used to align beta phase crystals within a PVDF fiber, and may include applying a voltage across a selected dimension of a spun fiber. An applied poling voltage may be at least approximately 200 V/micrometer, e.g., 200, 300, 400, 500, or 600 V/micrometer, including ranges between any of the foregoing values. In some cases, electric poling such as corona poling may be performed during the act of orienting. In some cases, electric poling such as corona poling may be performed during the act of annealing. The applied voltage may be applied along a radial direction of a fiber, i.e., perpendicular or substantially perpendicular to a length direction of the fiber. Example poling times may range from approximately 1 min to approximately 180 min. During poling, a PVDF fiber may be heated to a temperature of from approximately 20°C to approximately 5°C below the Curie temperature of the polymer.

As used herein, a "fiber" may be characterized by an aspect ratio (length dimension/cross sectional dimension) of at least approximately 10. In accordance with various embodiments, a PVDF fiber thin film may be formed by knitting, weaving, or embroidering PVDF fibers. By way of example, a PVDF fiber thin film may be formed by laying up a plurality of fibers, e.g., in a parallel or overlapping array, enveloping the fibers in a cross-linkable resin, and curing the resin. Example resins may include acrylates, epoxies, and urethanes. Curing may be conducted by exposure to actinic radiation, UV light, e-beam radiation, or heat, optionally in conjunction with a catalyst.

In accordance with various embodiments, anisotropic polymer thin films may include fibrous, amorphous, partially crystalline, or wholly crystalline materials. Such materials may also be mechanically anisotropic, where one or more characteristics may include compressive strength, tensile strength, shear strength, yield strength, stiffness, hardness, toughness, ductility, machinability, thermal expansion, piezoelectric response, and creep behavior may be directionally dependent.

According to some embodiments, the areal dimensions (i.e., length and width) of an anisotropic PVDF-family polymer thin film may independently range from approximately 5 cm to approximately 50 cm or more, e.g., 5, 10, 20, 30, 40, or 50 cm, including ranges between any of the foregoing values. Example anisotropic polymer thin films may have areal dimensions of approximately 5 cm x 5 cm, 10 cm x 10 cm, 20 cm x 20 cm, 50 cm x 50 cm, 5 cm x 10 cm, 10 cm x 20 cm, 10 cm x 50 cm, etc.

The presently disclosed anisotropic PVDF-based polymer thin films may be characterized as optical quality polymer thin films and may form, or be incorporated into, an optical element such as an actuatable layer. Such optical elements may be used in various display devices, such as virtual reality (VR) and augmented reality (AR) glasses and headsets. The efficiency of these and other optical elements may depend on the degree of optical clarity and/or piezoelectric response.

According to various embodiments, an "optical quality" or "optical grade" polymer article may, in some examples, be characterized by a transmissivity within the visible light spectrum of at least approximately 20%, e.g., 20, 30, 40, 50, 60, 70, 80, 90 or 95%, including ranges between any of the foregoing values, and less than approximately 10% bulk haze, e.g., 0, 1, 2, 4, 6, or 8% bulk haze, including ranges between any of the foregoing values. Transparent materials will typically exhibit very low optical absorption and minimal optical scattering. In some embodiments, an optical quality or optical grade polymer article may be colorless.

As used herein, the terms "haze" and "clarity" may refer to an optical phenomenon associated with the transmission of light through a material, and may be attributed, for example, to the refraction of light within the material, e.g., due to secondary phases or porosity and/or the reflection of light from one or more surfaces of the material. As will be appreciated by those skilled in the art, haze may be associated with an amount of light that is subject to wide angle scattering (i.e., at an angle greater than 2.5° from normal) and a corresponding loss of transmissive contrast, whereas clarity may relate to an amount of light that is subject to narrow angle scattering (i.e., at an angle less than 2.5° from normal) and an attendant loss of optical sharpness or "see through quality."

Aspects of the present disclosure thus relate to the formation of single layer and multilayer piezoelectrically anisotropic polymer thin films from a crystallizable polymer and a nucleating agent. The improved mechanical properties may include improved dimensional stability and improved compliance in conforming to a surface having compound curvature, such as a lens. The polymer thin films may be colorless, transparent, exhibit low haze, and may have an enhanced piezoelectric response.

Features from any of the embodiments described herein may be used in combination with one another in accordance with the general principles described herein. These and other embodiments, features, and advantages will be more fully understood upon reading the following detailed description in conjunction with the accompanying drawings and claims.

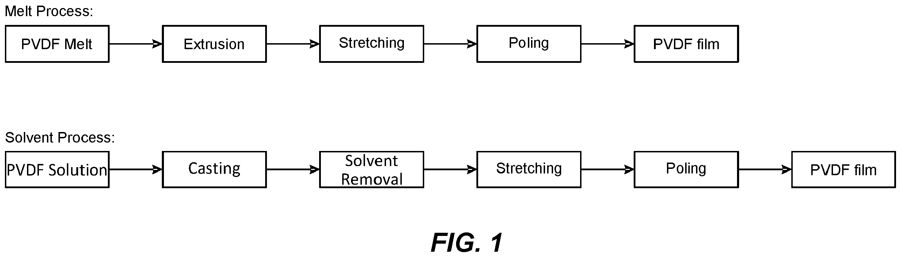

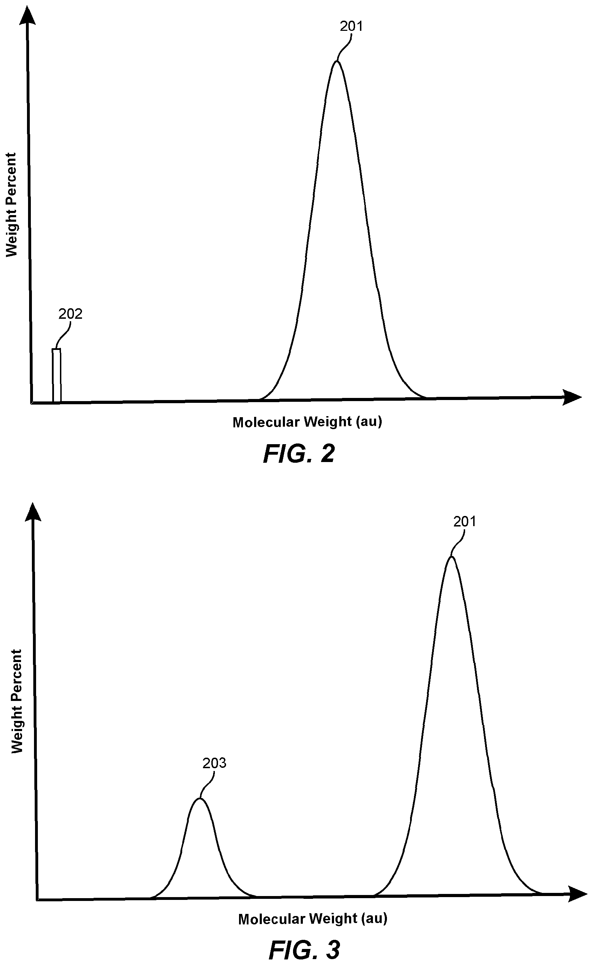

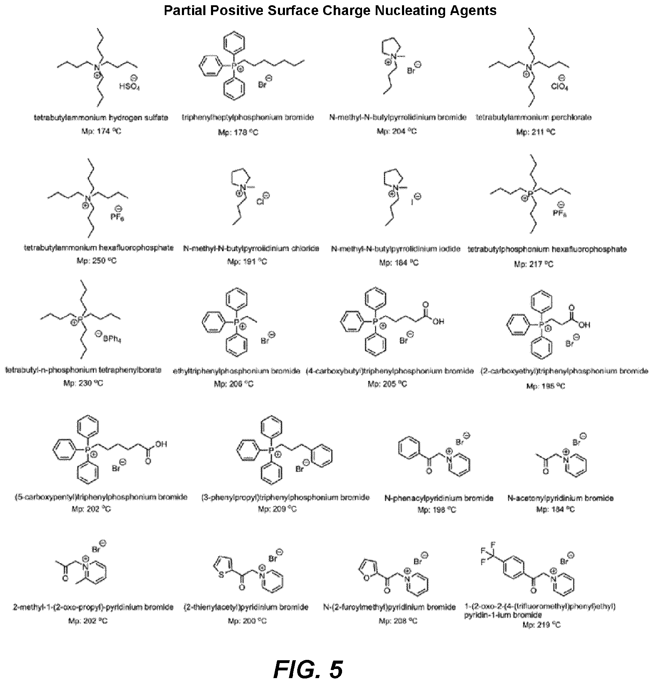

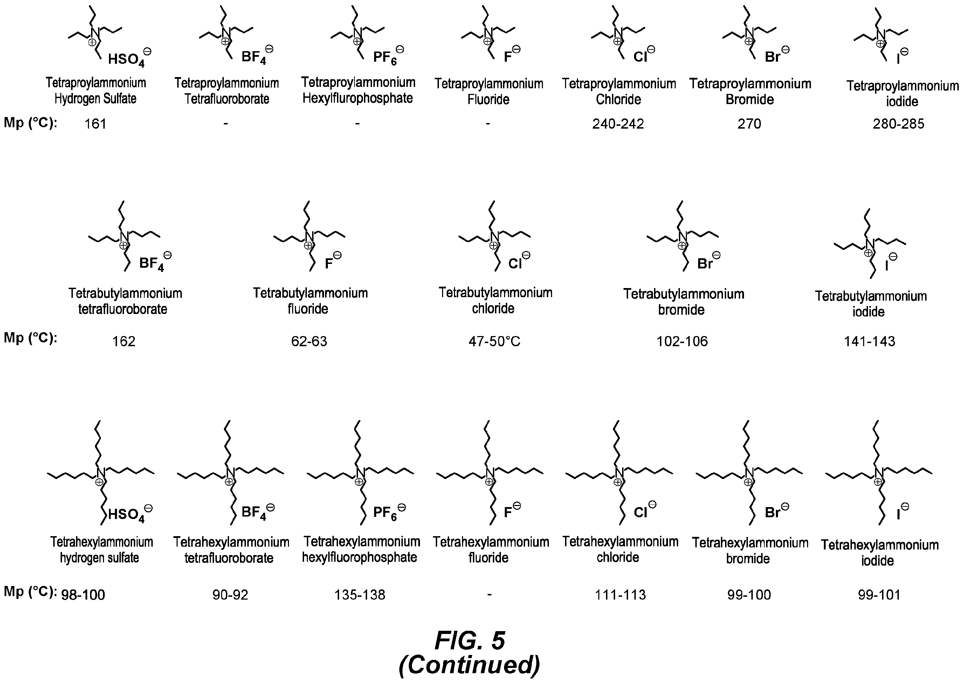

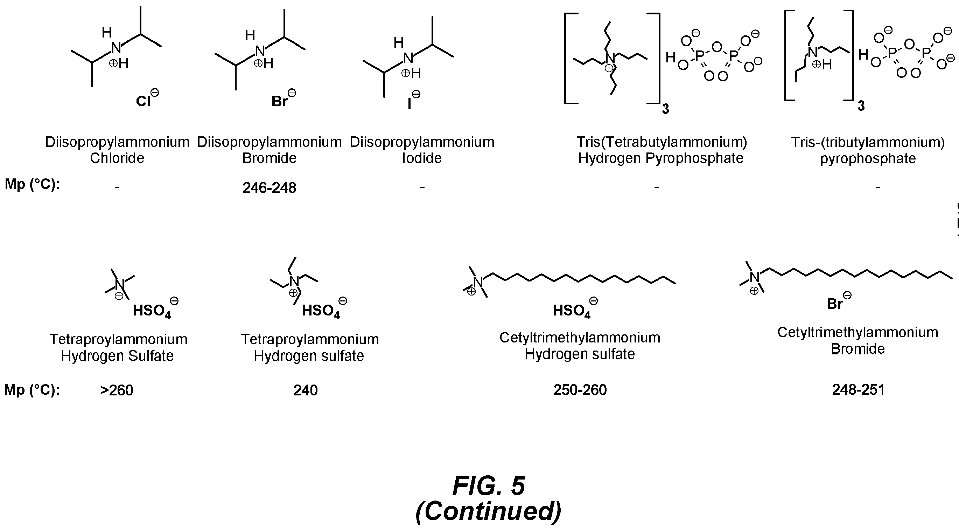

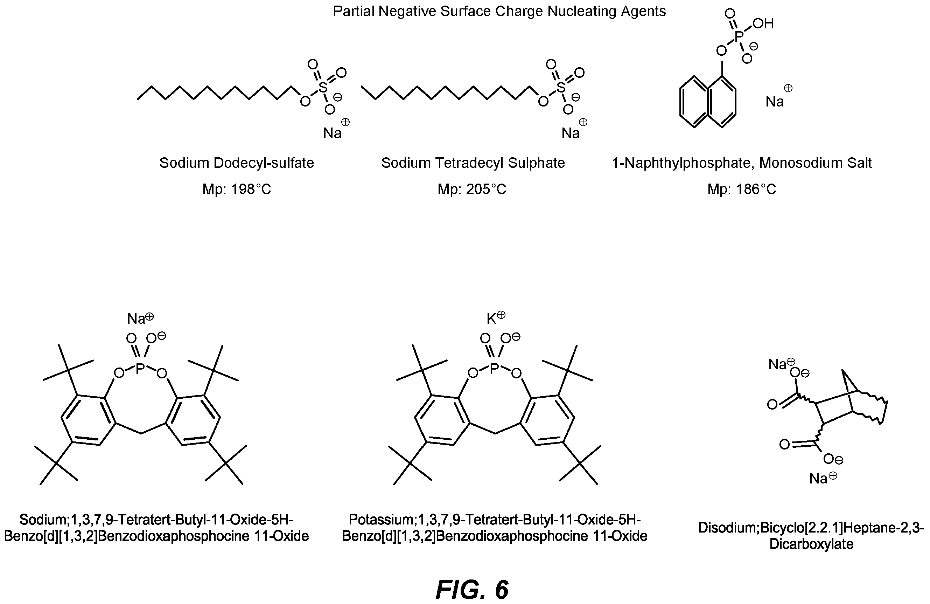

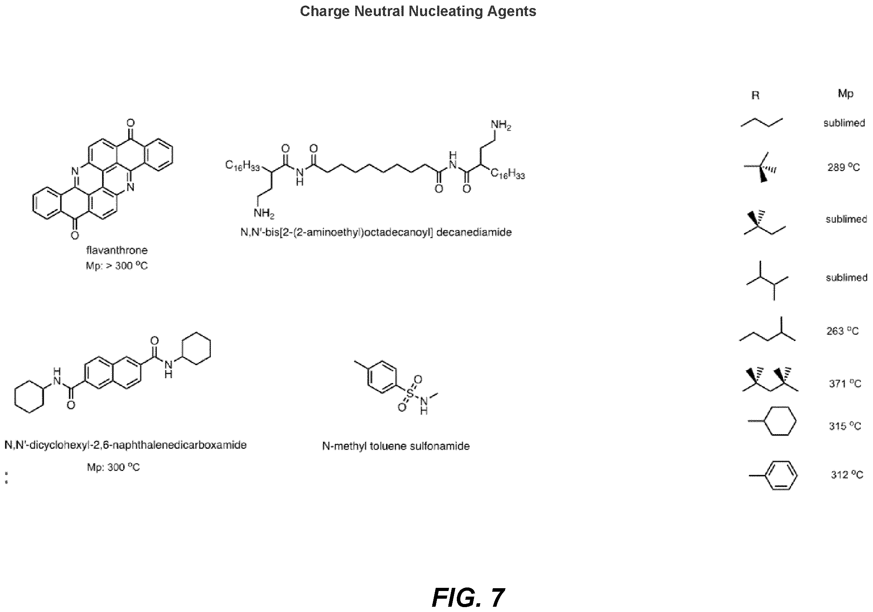

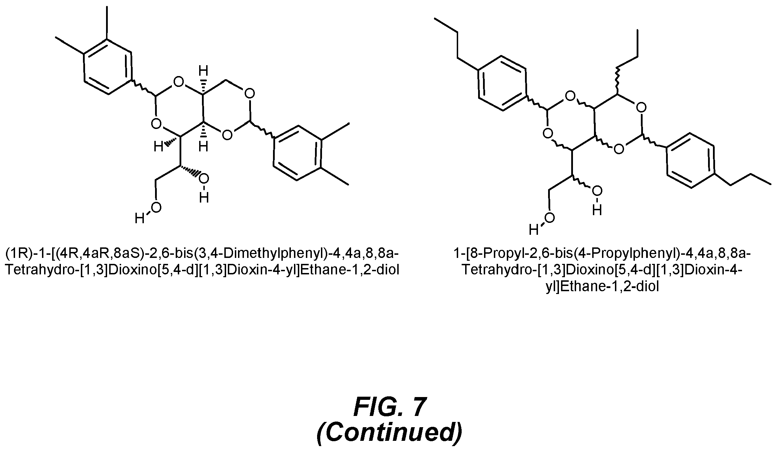

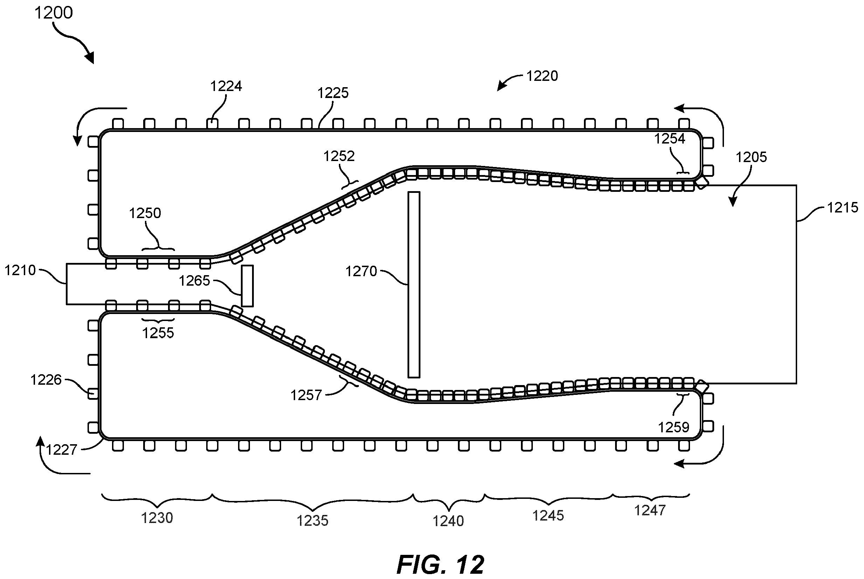

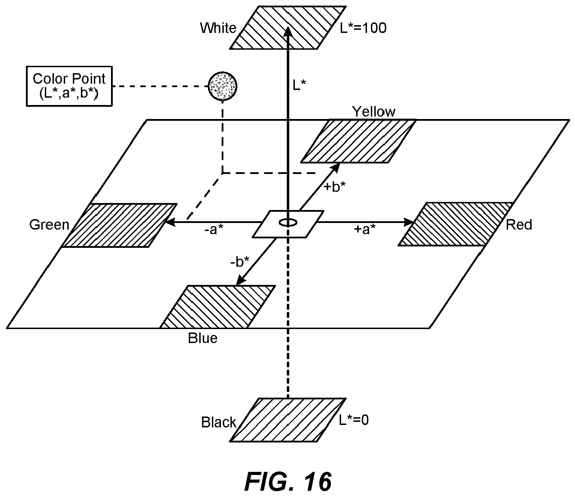

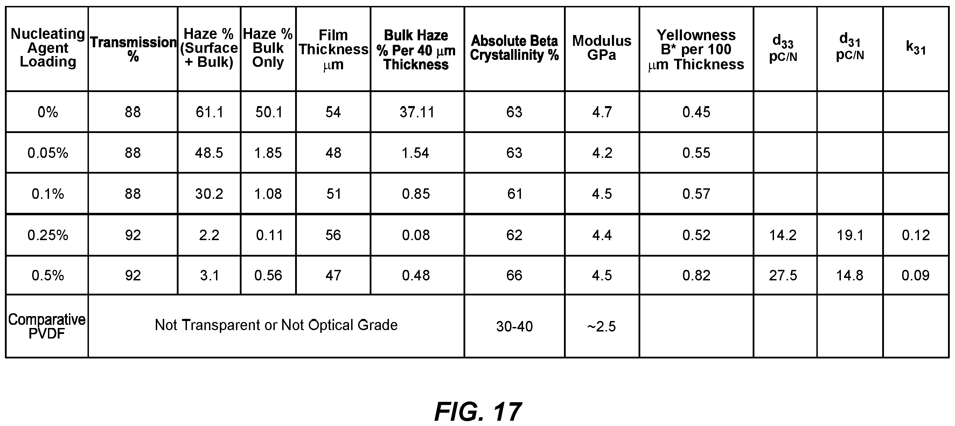

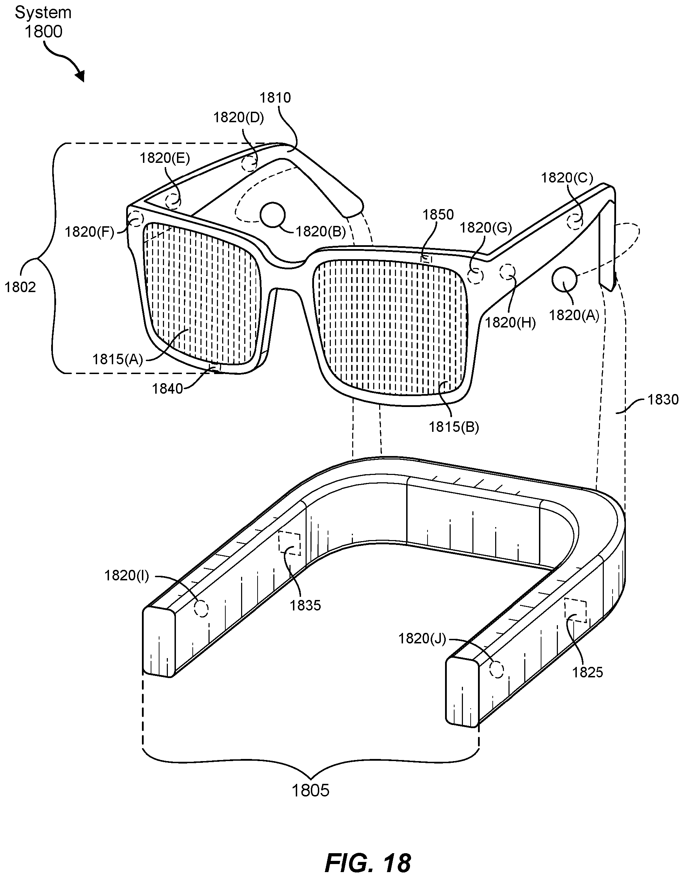

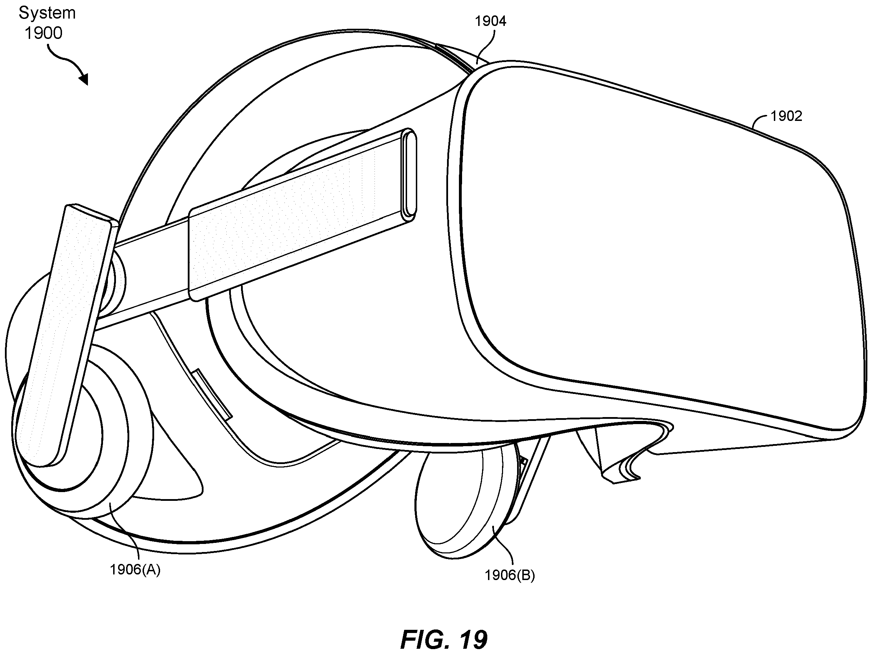

The following will provide, with reference to FIGS. 1-19, a detailed description of compositions and methods for forming optical grade polymer thin films having an enhanced piezoelectric response. The discussion associated with FIG. 1 relates to an example methods for forming an optical grade polymer thin film having high electromechanical efficiency. The discussion associated with FIGS. 2-4 includes a description of polymer compositions having a bimodal molecular weight distribution. The discussion associated with FIGS. 5-11 includes a description of example nucleating agents. The discussion associated with FIGS. 12-15 relates to example polymer thin film stretching paradigms and associated stretching apparatus. The discussion associated with FIGS. 16 and 17 relates to the formation and characterization of optical grade PVDF thin films. The discussion associated with FIGS. 18 and 19 relates to exemplary virtual reality and augmented reality devices that may include one or more optical grade polymer thin films as disclosed herein.

Referring to FIG. 1, shown are flow charts depicting melt and solvent processes for forming an optical grade polymer thin film having a high electromechanical efficiency. An example melt process may include forming a PVDF melt by combining a crystallizable polymer, a liquid solvent, and a nucleating agent, extruding the melt to form a thin film, stretching the thin film to form an oriented polymer thin film, and poling the thin film to form an optical grade PVDF polymer thin film having a high electromechanical efficiency.

An example solvent process may include forming a PVDF solution by combining a crystallizable polymer, a liquid solvent, and a nucleating agent, casting the solution to form a thin film, removing at least some of the solvent, stretching the thin film to form an oriented polymer thin film, and poling the thin film to form an optical grade PVDF polymer thin film having a high electromechanical efficiency.

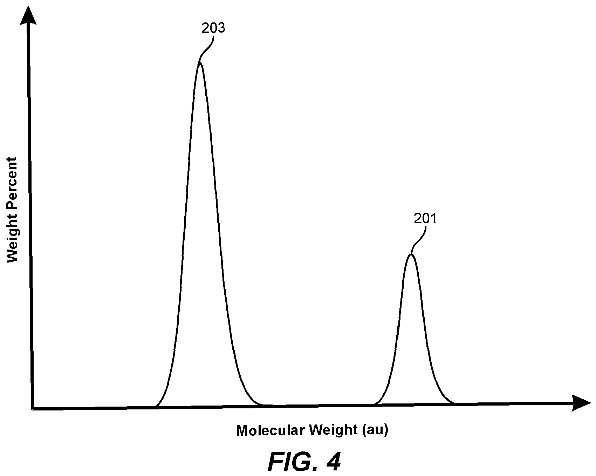

Referring to FIG. 2, shown schematically is a composition having a bimodal molecular weight distribution that includes a crystallizable polymer 201 and a low molecular weight additive 202. Referring to FIG. 3, shown schematically is a further composition having a bimodal molecular weight distribution that includes a crystallizable polymer 201 and a low molecular weight additive 203, where the content of the crystallizable polymer is greater than the content of the low molecular weight additive. Referring to FIG. 4, shown schematically is a still further composition having a bimodal molecular weight distribution that includes a crystallizable polymer 201 and a low molecular weight additive 203, where the content of the crystallizable polymer is less than the content of the low molecular weight additive.

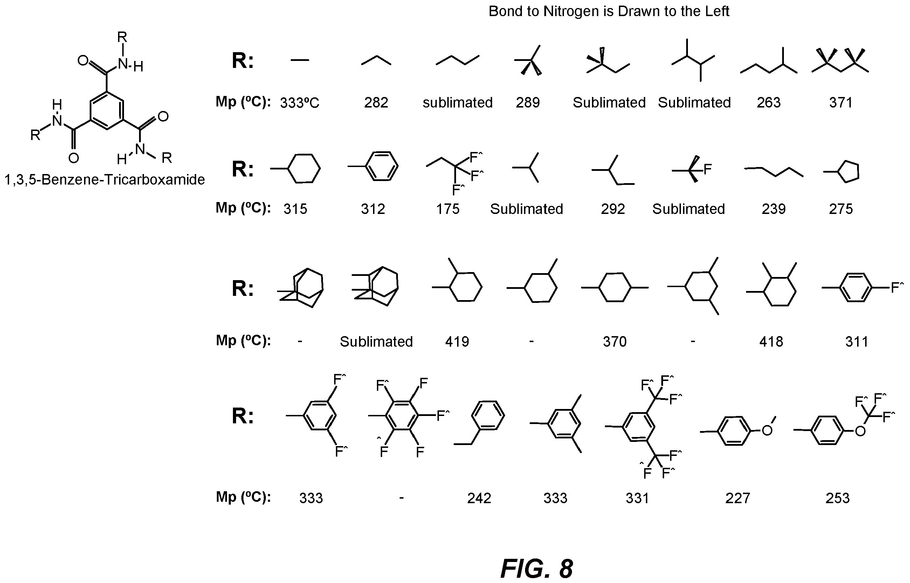

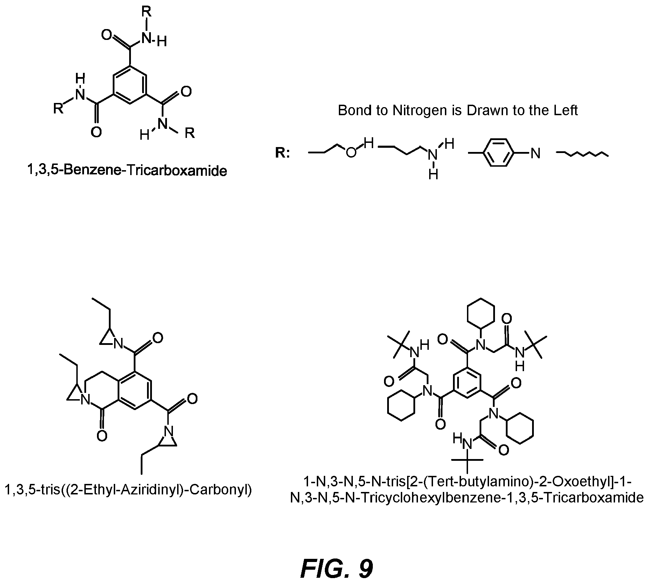

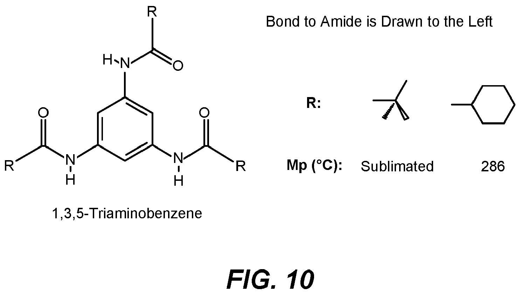

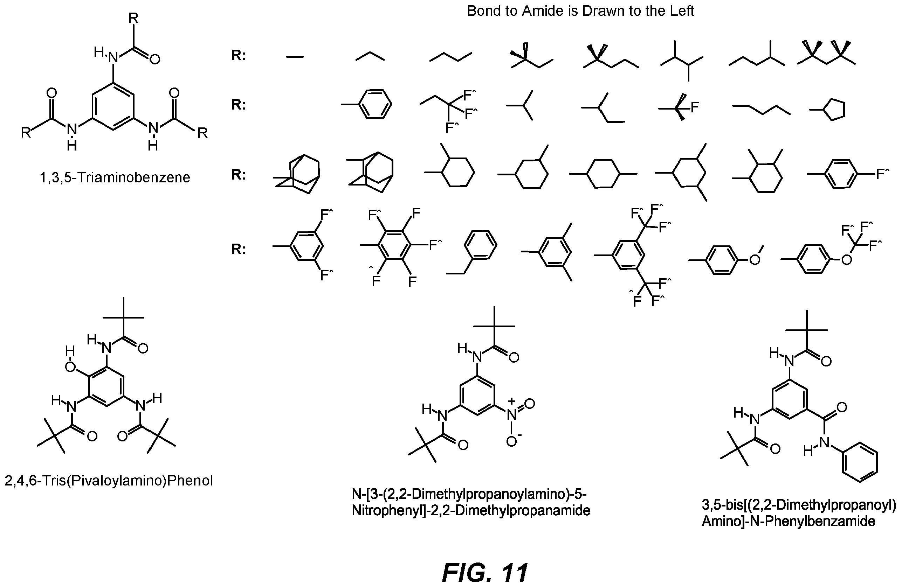

The composition, structure, and melting points of example nucleating agents having (A) a partial positive charge, (B) a partial negative charge, and (C) a charge neutral composition are shown graphically in FIGS. 5-7. Further example nucleating agents within the benzene-tricarboxamide family are shown in FIGS. 8 and 9. Still further example nucleating agents, including compounds within the triaminobenzene family, are shown in FIGS. 10 and 11.

A single stage thin film orientation system for forming an optical grade polymer thin film is shown schematically in FIG. 12. System 1200 may include a thin film input zone 1230 for receiving and pre-heating a crystallizable portion 1210 of a polymer thin film 1205, a thin film output zone 1247 for outputting a crystallized and oriented portion 1215 of the polymer thin film 1205, and a clip array 1220 extending between the input zone 1230 and the output zone 1247 that is configured to grip and guide the polymer thin film 1205 through the system 1200, i.e., from the input zone 1230 to the output zone 1247. Clip array 1220 may include a plurality of movable first clips 1224 that are slidably disposed on a first track 1225 and a plurality of movable second clips 1226 that are slidably disposed on a second track 1227.

During operation, proximate to input zone 1230, clips 1224, 1226 may be affixed to respective edge portions of polymer thin film 1205, where adjacent clips located on a given track 1225, 1227 may be disposed at an inter-clip spacing 1250, 1255. For simplicity, in the illustrated view, the inter-clip spacing 1250 along the first track 1225 within input zone 1230 may be equivalent or substantially equivalent to the inter-clip spacing 1255 along the second track 1227 within input zone 1230. As will be appreciated, in alternate embodiments, within input zone 1230, the inter-clip spacing 1250 along the first track 1225 may be different than the inter-clip spacing 1255 along the second track 1227.

In addition to input zone 1230 and output zone 1247, system 1200 may include one or more additional zones 1235, 1240, 1245, etc., where each of: (i) the translation rate of the polymer thin film 1205, (ii) the shape of first and second tracks 1225, 1227, (iii) the spacing between first and second tracks 1225, 1227, (iv) the inter-clip spacing 1250, 1252, 1254, 1255, 1257, 1259, and (v) the local temperature of the polymer thin film 1205, etc. may be independently controlled.

In an example process, as it is guided through system 1200 by clips 1224, 1226, polymer thin film 1205 may be heated to a selected temperature within each of zones 1230, 1235, 1240, 1245, 1247. Fewer or a greater number of thermally controlled zones may be used. As illustrated, within zone 1235, first and second tracks 1225, 1227 may diverge along a transverse direction such that polymer thin film 1205 may be stretched in the transverse direction while being heated, for example, to a temperature greater than its glass transition temperature ($T_g$) but less than the onset of melting.

Referring still to FIG. 12, within zone 1235 the spacing 1252 between adjacent first clips 1224 on first track 1225 and the spacing 1257 between adjacent second clips 1226 on second track 1227 may decrease relative to the inter-clip spacing 1250, 1255 within input zone 1230. In certain embodiments, the decrease in clip spacing 1252, 1257 from the initial spacing 1250, 1255 may scale approximately as the square root of the transverse stretch ratio. The actual ratio may depend on the Poisson's ratio of the polymer thin film as well as the requirements for the stretched thin film, including flatness, thickness, etc. Accordingly, in some embodiments, the in-plane axis of the polymer thin films that is perpendicular to the stretch direction may relax by an amount equal to the square root of the stretch ratio in the stretch direction. By decreasing the clip spacings 1252, 1257 relative to inter-clip spacing 1250, 1255 the polymer thin film may be allowed to relax along the machine direction while being stretched along the transverse direction.

A temperature of the polymer thin film may be controlled within each heating zone. Withing stretching zone 1235, for example, a temperature of the polymer thin film 1205 may be constant or independently controlled within sub-zones 1265, 1270, for example. In some embodiments, the temperature of the polymer thin film 1205 may be decreased as the stretched polymer thin film 1205 enters zone 1240. Rapidly decreasing the temperature (i.e., thermal quenching) following the act of stretching within zone 1235 may enhance the conformability of the polymer thin film 1205. In some embodiments, the polymer thin film 1205 may be thermally stabilized, where the temperature of the polymer thin film 1205 may be controlled within each of the post-stretch zones 1240, 1245, 1247. A temperature of the polymer thin film may be controlled by forced thermal convection or by radiation, for example, IR radiation, or a combination thereof.

Downstream of stretching zone 1235, according to some embodiments, a transverse distance between first track 1225 and second track 1227 may remain constant or, as illustrated, initially decrease (e.g., within zone 1240 and zone 1245) prior to assuming a constant separation distance (e.g., within output zone 1247). In a related vein, the inter-clip spacing downstream of stretching zone 1235 may increase or decrease relative to inter-clip spacing 1252 along first track 1225 and inter-clip spacing 1257 along second track 1227. For example, inter-clip spacing 1255 along first track 1225 within output zone 1247 may be less than inter-clip spacing 1252 within stretching zone 1235, and inter-clip spacing 1259 along second track 1227 within output zone 1247 may be less than inter-clip spacing 1257 within stretching zone 1235. According to some embodiments, the spacing between the clips may be controlled by modifying the local velocity of the clips on a linear stepper motor line, or by using an attachment and variable clip spacing mechanism connecting the clips to the corresponding track.

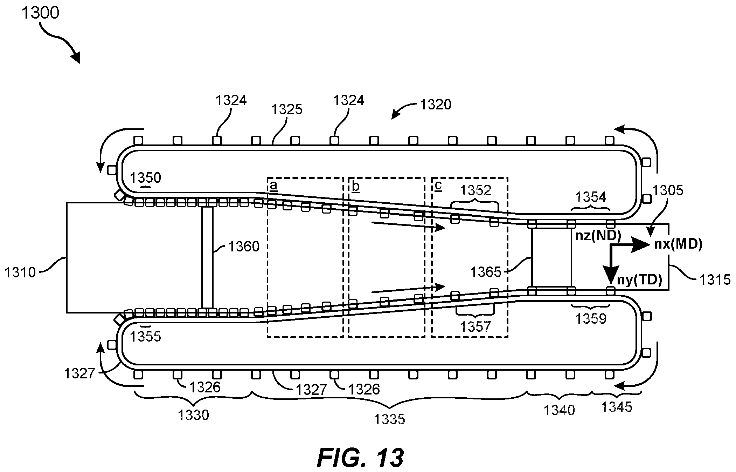

To facilitate cross-stretch relaxation while stretching in the TD direction, the inter-clip spacings 1252, 1257 withing stretching zone 1235 may be decreased by at least approximately 20% (e.g., 20%, 30%, 40%, or 50% or more) relative to respective inter-clip spacings 1250, 1255 within input zone 1230. The relaxation profile may be constant or variable, i.e., as a function of position, across stretching zone 1235. According to some embodiments, a maximum TD draw ratio within stretching zone 1235 be at least approximately 2 and less than approximately 4. The stretched and oriented polymer thin film 1215 may be removed from system 1200 and stretched in a further stretching step, such as via length orientation with relaxation as shown in FIG. 13.

Referring to FIG. 13, shown is a further example system for forming an optical grade polymer thin film. Thin film orientation system 1300 may include a thin film input zone 1330 for receiving and pre-heating a crystalline or crystallizable portion 1310 of a polymer thin film 1305, a thin film output zone 1345 for outputting an at least partially crystallized and oriented portion 1315 of the polymer thin film 1305, and a clip array 1320 extending between the input zone 1330 and the output zone 1345 that is configured to grip and guide the polymer thin film 1305 through the system 1300. As in the previous embodiment, clip array 1320 may include a plurality of first clips 1324 that are slidably disposed on a first track 1325 and a plurality of second clips 1326 that are slidably disposed on a second track 1327. In certain embodiments, crystalline or crystallizable portion 1310 may correspond to stretched and oriented polymer thin film 1215.

In an example process, proximate to input zone 1330, first and second clips 1324, 1326 may be affixed to edge portions of polymer thin film 1305, where adjacent clips located on a given track 1325, 1327 may be disposed at an initial inter-clip spacing 1350, 1355, which may be substantially constant or variable along both tracks within input zone 1330. Within input zone 1330 a distance along the transverse direction between first track 1325 and second track 1327 may be constant or substantially constant.

System 1300 may additionally include one or more zones 1335, 1340, etc. The dynamics of system 1300 allow independent control over: (i) the translation rate of the polymer thin film 1305, (ii) the shape of first and second tracks 1325, 1327, (iii) the spacing between first and second tracks 1325, 1327 along the transverse direction, (iv) the inter-clip spacing 1350, 1355 within input zone 1330 as well as downstream of the input zone (e.g., inter-clip spacings 1352, 1354, 1357, 1359), and (v) the local temperature of the polymer thin film, etc.

In an example process, as it is guided through system 1300 by clips 1324, 1326, polymer thin film 1305 may be heated to a selected temperature within each of zones 1330, 1335, 1340, 1345. A temperature greater than the glass transition temperature of a component of the polymer thin film 1305 may be used during deformation (i.e., within zone 1335), whereas a lesser temperature, an equivalent temperature, or a greater temperature may be used within each of one or more downstream zones.

As in the previous embodiment, the temperature of the polymer thin film 1305 within stretching zone 1335 may be locally controlled. According to some embodiments, the temperature of the polymer thin film 1305 may be maintained at a constant or substantially constant value during the act of stretching. According to further embodiments, the temperature of the polymer thin film 1305 may be incrementally increased within stretching zone 1335. That is, the temperature of the polymer thin film 1305 may be increased within stretching zone 1335 as it advances along the machine direction. By way of example, the temperature of the polymer thin film 1305 within stretching zone 1335 may be locally controlled within each of heating zones a, b, and c.

The temperature profile may be continuous, discontinuous, or combinations thereof. As illustrated in FIG. 13, heating zones a, b, and c may extend across the width of the polymer thin film 1305, and the temperature within each zone may be independently controlled according to the relationship $T_g < T_a < T_b < T_c < T_m$. A temperature difference between neighboring heating zones may be less than approximately 20°C, e.g., less than approximately 10°C, or less than approximately 5°C.

Referring still to FIG. 13, within zone 1335 the spacing 1352 between adjacent first clips 1324 on first track 1325 and the spacing 1357 between adjacent second clips 1326 on second track 1327 may increase relative to respective inter-clip spacings 1350, 1355 within input zone 1330, which may apply an in-plane tensile stress to the polymer thin film 1305 and stretch the polymer thin film along the machine direction. Moreover, the extent of inter-clip spacing on one or both tracks 1325, 1327 within deformation zone 1335 may be constant or variable and, for example, increase as a function of position along the machine direction.

Within stretching zone 1335, the inner-clip spacings 1352, 1357 may increase linearly such that the primary mode of deformation may be at constant velocity. For example, a strain rate of the polymer thin film may decrease along the machine direction. In further embodiments, the polymer thin film 1305 may be stretched at a constant strain-rate where the inter-clip spacing may increase exponentially.

In certain examples, a progressively decreasing strain rate may be implemented with thin film orientation system 1300 to generate a high refractive index polymer thin film. For instance, within stretching zone 1335 an inter-clip spacing may be configured such that a distance between each successive pair of clips 1324, 1326 increases along the machine direction. The inter-clip spacing between each successive pair of clips may be independently controlled to achieve a desired strain rate along the machine direction.

In response to the tensile stress applied along the machine direction, system 1300 is configured to inhibit the generation of stresses and an attendant realignment of crystals along the machine direction. As illustrated, within zone 1335, first and second tracks 1325, 1327 may converge along a transverse direction such that polymer thin film 1305 may relax in the transverse direction while being stretched in the machine direction. Using a single stretching step or multiple stretching steps, polymer thin film 1305 may be stretched by a factor of at least approximately 4 (e.g., 4, 5, 6, 7, 8, 9, 10, 20, 40, 100, or more, including ranges between any of the foregoing values).

Within stretching zone 1335, an angle of inclination of first and second tracks 1325, 1327 (i.e., with respect to the machine direction) may be constant or variable. In particular examples, the inclination angle within stretching zone 1335 may decrease along the machine direction. That is, according to certain embodiments, the inclination angle within heating zone a may be greater than the inclination angle within heating zone b, and the inclination angle within heating zone b may be greater than the inclination angle within heating zone c. Such a configuration may be used to provide a progressive decrease in the relaxation rate (along the transverse direction) within the stretching zone 1335 as the polymer thin film advances through system 1300.

In some embodiments, the temperature of the polymer thin film 1305 may be decreased as the stretched polymer thin film 1305 exits zone 1335. In some embodiments, the polymer thin film 1305 may be thermally stabilized, where the temperature of the polymer thin film 1305 may be controlled within each of the post-deformation zones 1340, 1345. A temperature of the polymer thin film may be controlled by forced thermal convection or by radiation, for example, IR radiation, or a combination thereof.

Downstream of deformation zone 1335, the inter-clip spacing may increase or remain substantially constant relative to inter-clip spacing 1352 along first track 1325 and inter-clip spacing 1357 along second track 1327. For example, inter-clip spacing 1355 along first track 1325 within output zone 1345 may be substantially equal to the inter-clip spacing 1352 as the clips exit zone 1335, and inter-clip spacing 1359 along second track 1327 within output zone 1345 may be substantially equal to the inter-clip spacing 1357 as the clips exit zone 1335. Following the act of stretching, polymer thin film 1305 may be annealed, for example, within one or more downstream zones 1340, 1345.

The strain impact of the thin film orientation system 1300 is shown schematically by unit segments 1360, 1365, which respectively illustrate pre- and post-deformation dimensions for a selected area of polymer thin film 1305. In the illustrated embodiment, polymer thin film 1305 has a pre-stretch width (e.g., along the transverse direction) and a pre-stretch length (e.g., along the machine direction). As will be appreciated, a post-stretch width may be less than the pre-stretch width and a post-stretch length may be greater than the pre-stretch length.

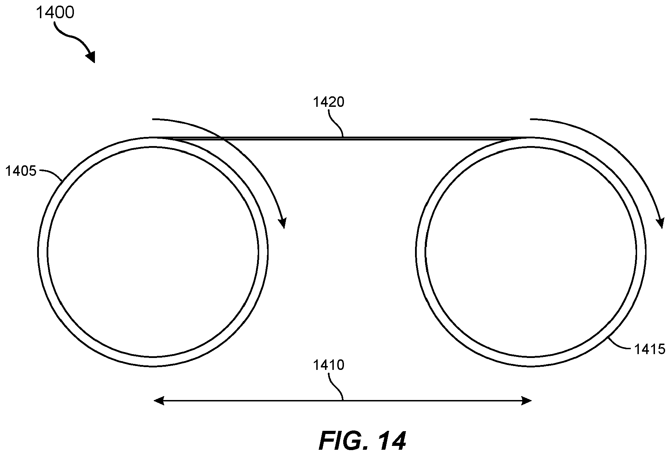

In some embodiments, a roll-to-roll system may be integrated with a thin film orientation system, such as thin film orientation system 1200 or thin film orientation system 1300, to manipulate a polymer thin film. In further embodiments, as illustrated herein with reference to FIG. 14, a roll-to-roll system may itself be configured as a thin film orientation system.

An example roll-to-roll polymer thin film orientation system is depicted in FIG. 14. In conjunction with system 1400, a method for stretching a polymer thin film 1420 may include mounting the polymer thin film between linear rollers 1405, 1415 and heating a portion of the polymer thin film located between the rollers 1405, 1415 to a temperature greater than its glass transition temperature. Rollers 1405, 1415 may be arranged with a controllable spacing 1410 therebetween. A heat source (not shown), such as an IR source optionally equipped with an IR reflector, may be used to heat the polymer thin film 1420 within a deformation region between the rollers.

While controlling the temperature of the polymer thin film, rollers 1405, 1415 may be engaged and the polymer thin film may be stretched. For instance, first roller 1405 may rotate at a first rate and second roller 1415 may rotate at a second rate greater than the first rate to stretch the polymer thin film along a machine direction therebetween. Within a deformation zone between rollers, system 1400 may be configured to locally control the temperature and the strain rate of the polymer thin film. In some examples, as the polymer thin film advances from roller 1405 to roller 1415, a temperature of the polymer thin film may increase, and a strain rate of the polymer thin film may decrease. Downstream of roller 1415, the polymer thin film may then be cooled while maintaining the applied stress. System 1400 may be used to form a uniaxially oriented polymer thin film. Additional rollers may be added to system 1400 to control the conveyance and take-up of the polymer thin film.

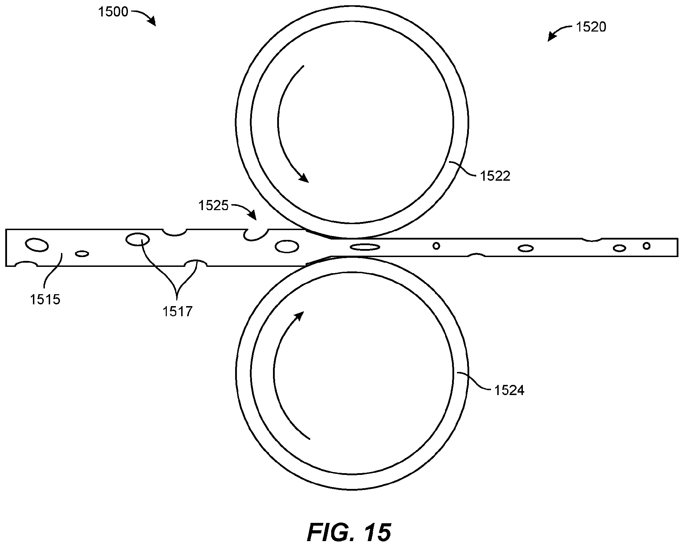

Referring to FIG. 15, shown schematically is a calendering method for manufacturing an optical grade polymer thin film. In method 1500, a stretched PVDF thin film 1515, such as oriented polymer thin film 1215 or oriented polymer thin film 1315, may be fed into a calendering system 1520. Calendering system 1520 may include a pair of counter-rotating rollers 1522, 1524 defining a nip region 1525. As the thin film 1515 passes into the nip region 1525 and between the rollers 1522, 1524, the thin film 1515 may be compressed. In exemplary embodiments, rollers 1522, 1524 may be heated. In some examples, the temperature of the rollers during calendering may be greater than the glass transition temperature of the polymer. In some examples, the temperature of the rollers during calendering may be less than, equal to, or greater than the melting onset temperature of the polymer.

During calendering, voids 1517 present in stretched PVDF thin film 1515 may be compressed, and the overall void fraction within the thin film may be decreased. Moreover, voids exposed at a surface of the thin film may be smoothed, resulting in decreased surface roughness and, together with compression of voids within the bulk of the thin film, higher transmissivity and higher thermal conductivity.

According to various embodiments, a PVDF polymer thin film may be engineered to have a controlled suite of properties, including mechanical, electromechanical, and optical properties. For instance, one or more stages of thin film synthesis and processing may be used to tune the optical characteristics of a PVDF polymer thin film, including its transparency, haze, clarity, and color profile.

Without wishing to be bound by theory, the yellowing of various fluorinated polymers may result from degradation induced by a free radical reaction and/or a nucleophilic reaction. In particular examples, a fluorinated polymer may undergo a defluorination reaction and/or a crosslinking reaction that introduce unsaturated bonds and/or conjugated carbon-carbon double or triple bonds into the polymer network, which may contribute to a deterioration of optical performance, including yellowing. By way of example, a polymer thin film may be formed from a solution that includes a liquid solvent. The liquid solvent may be a polar solvent that may form a nucleophilic reagent ($Nu^-$) that causes a defluorination reaction via nucleophilic reduction.

Quantification of the degree or extent of yellowing may be made using a coordinate system defined by the Commission Internationale de l'Eclairage (CIE). The CIE L*a*b* color space was modeled after a color-opponent theory stating that two colors cannot be simultaneously green and red nor simultaneously blue and yellow. Referring to FIG. 16, in the CIE L*a*b* color space, L* indicates lightness, a* is the green/red coordinate, and b* is the blue/yellow coordinate. Within the L* coordinate, which ranges from 0 to 100, black is defined at 0 and white at 100. The a* axis is relative to the green/red opponent colors, with negative values toward green and positive values toward red. The b* axis represents the blue/yellow opponents, with negative numbers toward blue and positive toward yellow.

According to some embodiments, a PVDF polymer thin film may be characterized by one or more of: (i) a color coordinate (|a*|) of less than approximately 10, (ii) a color coordinate (|b*|) of less than approximately 10, and (iii) a lightness value (L*) of greater than approximately 50 for a film thickness of less than approximately 300 micrometers.

That is, the color coordinates a* and b* may independently have an absolute value less than approximately 10, e.g., 0.1, 0.2, 0.5, 1, 2, 3, 4, or 5, including ranges between any of the foregoing values, for a film thickness of less than approximately 300 micrometers, e.g., 10, 20, 50, 100, or 200 micrometers, including ranges between any of the foregoing values.

In particular embodiments, a polymer thin film may include a crystalline PVDF-family polymer, and may have an electromechanical coupling factor ($k_{31}$) of at least approximately 0.15, and a color coordinate (|b*|) of less than approximately 10 for a film thickness of less than approximately 300 micrometers. For polymer thin films having equivalent color, the color coordinates |a*| and |b*| are approximately proportional to thickness.

Examples

A polymer composition was prepared by combining PVDF-family crystallizable polymers having disparate molecular weights with a nucleating agent. The mixture was processed to form optical grade, piezoelectric thin films. Selected optical and physical properties of the PVDF thin films as a function of the nucleating agent content are summarized in FIG. 17.

In the various examples, PVDF having a weight average molecular weight of 573 g/mol and PVDF having a weight average molecular weight of 176 g/mol were added to the hopper of a micro-compounding machine and stirred at 100 rpm while being heated at a temperature of 210°C. The polymer mixture included approximately 30 wt.% of the higher molecular weight polymer and approximately 70 wt.% of the lower molecular weight polymer. After mixing for 8 min, a selected amount of a nucleating agent (0-1 wt.% of tetrabutylammonium hydrogen sulfate) was added to respective batches and mixed for an additional 2 min.

The resulting mixtures were injection molded into dog bone-shaped samples at a pressure of 10 bar and mold temperature of 60°C. The dog bone samples were compressed at 200°C at a pressure of 200 bar for 5 min and then rapidly quenched to room temperature to form uniform thin films having a thickness of approximately 200 micrometers. The films were cut into rectangular shapes suitable for stretching on a commercial stretching apparatus.

Stretching was performed using a two-step process. In the first step, each thin film was stretched at 160°C at a constant strain rate of 1%/sec to reach a stretch ratio of approximately 5. During a subsequent step, the temperature was incrementally increased from 160°C to 180°C in 5°C increments. Each temperature increment accompanied the realization of a thin film true stress of 200 MPa. True stress is calculated as the quotient of an *in situ* stretch force and an *in situ* cross-sectional area of the thin film during stretching. After stretching was completed, the films were rapidly quenched to room temperature and then discharged from the stretching apparatus.

The stretched film was electrically poled by corona poling using an applied voltage of approximately 30 kV at 75°C for 15 minutes, followed by cooling to room temperature under the applied voltage for 15 minutes.

The crystalline content of each thin film sample was determined by differential scanning calorimetry (DSC) through the integration of the melting endotherm from the first heating cycle. The beta crystal ratio was determined by Fourier Transform Infrared Spectrometry (FTIR). The absolute beta crystallinity value for the PVDF films was determined as the product of the crystalline content and the beta crystal ratio. The elastic modulus was determined by dynamic mechanical analysis (DMA) at 20°C. The film haze and film transmittance were determined using a hazemeter, where the total haze value includes bulk and surface haze components. To measure bulk haze, an index matching oil was applied on both surfaces of the film to eliminate the surface haze. Yellowness was measured using a spectrophotometer and the values were translated into b* per 100 micrometers for comparison between different samples.

An anisotropic polymer thin film or fiber may be formed from a composition that includes a crystallizable polymer and a nucleating agent. The crystallizable polymer may include vinylidene fluoride (VDF), trifluoroethylene (TrFE), chloride trifluoride ethylene (CTFE), hexafluoropropene (HFP), vinyl fluoride (VF), as well as homopolymers, co-polymers, tri-polymers, derivates, and combinations thereof. The nucleating agent may include one or more of a class of ionic salts. Example ionic nucleating agents include KBr and NaCl. In certain embodiments, the nucleating agent may be used to control the crystalline content of a polymer article, which may beneficially impact both optical clarity and piezoelectric response. The application of a uniaxial or biaxial stress to an extruded of cast single or multilayer thin film may be used to align polymer chains and/or orient crystals to induce optical and mechanical anisotropy.

Embodiments of the present disclosure may include or be implemented in conjunction with various types of artificial-reality systems. Artificial reality is a form of reality that has been adjusted in some manner before presentation to a user, which may include, for example, a virtual reality, an augmented reality, a mixed reality, a hybrid reality, or some combination and/or derivative thereof. Artificial-reality content may include completely computer-generated content or computer-generated content combined with captured (e.g., real-world) content. The artificial-reality content may include video, audio, haptic feedback, or some combination thereof, any of which may be presented in a single channel or in multiple channels (such as stereo video that produces a three-dimensional (3D) effect to the viewer). Additionally, in some embodiments, artificial reality may also be associated with applications, products, accessories, services, or some combination thereof, that are used to, for example, create content in an artificial reality and/or are otherwise used in (e.g., to perform activities in) an artificial reality.

Artificial-reality systems may be implemented in a variety of different form factors and configurations. Some artificial-reality systems may be designed to work without near-eye displays (NEDs). Other artificial-reality systems may include an NED that also provides visibility into the real world (such as, e.g., augmented-reality system 1800 in FIG. 18) or that visually immerses a user in an artificial reality (such as, e.g., virtual-reality system 1900 in FIG. 19). While some artificial-reality devices may be self-contained systems, other artificial-reality devices may communicate and/or coordinate with external devices to provide an artificial-reality experience to a user. Examples of such external devices include handheld controllers, mobile devices, desktop computers, devices worn by a user, devices worn by one or more other users, and/or any other suitable external system.

Turning to FIG. 18, augmented-reality system 1800 may include an eyewear device 1802 with a frame 1810 configured to hold a left display device 1815(A) and a right display device 1815(B) in front of a user's eyes. Display devices 1815(A) and 1815(B) may act together or independently to present an image or series of images to a user. While augmented-reality system 1800 includes two displays, embodiments of this disclosure may be implemented in augmented-reality systems with a single NED or more than two NEDs.

In some embodiments, augmented-reality system 1800 may include one or more sensors, such as sensor 1840. Sensor 1840 may generate measurement signals in response to motion of augmented-reality system 1800 and may be located on substantially any portion of frame 1810. Sensor 1840 may represent one or more of a variety of different sensing mechanisms, such as a position sensor, an inertial measurement unit (IMU), a depth camera assembly, a structured light emitter and/or detector, or any combination thereof. In some embodiments, augmented-reality system 1800 may or may not include sensor 1840 or may include more than one sensor. In embodiments in which sensor 1840 includes an IMU, the IMU may generate calibration data based on measurement signals from sensor 1840. Examples of sensor 1840 may include, without limitation, accelerometers, gyroscopes, magnetometers, other suitable types of sensors that detect motion, sensors used for error correction of the IMU, or some combination thereof.

In some examples, augmented-reality system 1800 may also include a microphone array with a plurality of acoustic transducers 1820(A)-1820(J), referred to collectively as acoustic transducers 1820. Acoustic transducers 1820 may represent transducers that detect air pressure variations induced by sound waves. Each acoustic transducer 1820 may be configured to detect sound and convert the detected sound into an electronic format (e.g., an analog or digital format). The microphone array in FIG. 18 may include, for example, ten acoustic transducers: 1820(A) and 1820(B), which may be designed to be placed inside a corresponding ear of the user, acoustic transducers 1820(C), 1820(D), 1820(E), 1820(F), 1820(G), and 1820(H), which may be positioned at various locations on frame 1810, and/or acoustic transducers 1820(I) and 1820(J), which may be positioned on a corresponding neckband 1805.

In some embodiments, one or more of acoustic transducers 1820(A)-(J) may be used as output transducers (e.g., speakers). For example, acoustic transducers 1820(A) and/or 1820(B) may be earbuds or any other suitable type of headphone or speaker.

The configuration of acoustic transducers 1820 of the microphone array may vary. While augmented-reality system 1800 is shown in FIG. 18 as having ten acoustic transducers 1820, the number of acoustic transducers 1820 may be greater or less than ten. In some embodiments, using higher numbers of acoustic transducers 1820 may increase the amount of audio information collected and/or the sensitivity and accuracy of the audio information. In contrast, using a lower number of acoustic transducers 1820 may decrease the computing power required by an associated controller 1850 to process the collected audio information. In addition, the position of each acoustic transducer 1820 of the microphone array may vary. For example, the position of an acoustic transducer 1820 may include a defined position on the user, a defined coordinate on frame 1810, an orientation associated with each acoustic transducer 1820, or some combination thereof.

Acoustic transducers 1820(A) and 1820(B) may be positioned on different parts of the user's ear, such as behind the pinna, behind the tragus, and/or within the auricle or fossa. Or, there may be additional acoustic transducers 1820 on or surrounding the ear in addition to acoustic transducers 1820 inside the ear canal. Having an acoustic transducer 1820 positioned next to an ear canal of a user may enable the microphone array to collect information on how sounds arrive at the ear canal. By positioning at least two of acoustic transducers 1820 on either side of a user's head (e.g., as binaural microphones), augmented-reality device 1800 may simulate binaural hearing and capture a 3D stereo sound field around about a user's head. In some embodiments, acoustic transducers 1820(A) and 1820(B) may be connected to augmented-reality system 1800 via a wired connection 1830, and in other embodiments acoustic transducers 1820(A) and 1820(B) may be connected to augmented-reality system 1800 via a wireless connection (e.g., a BLUETOOTH connection). In still other embodiments, acoustic transducers 1820(A) and 1820(B) may not be used at all in conjunction with augmented-reality system 1800.

Acoustic transducers 1820 on frame 1810 may be positioned in a variety of different ways, including along the length of the temples, across the bridge, above or below display devices 1815(A) and 1815(B), or some combination thereof. Acoustic transducers 1820 may also be oriented such that the microphone array is able to detect sounds in a wide range of directions surrounding the user wearing the augmented-reality system 1800. In some embodiments, an optimization process may be performed during manufacturing of augmented-reality system 1800 to determine relative positioning of each acoustic transducer 1820 in the microphone array.

In some examples, augmented-reality system 1800 may include or be connected to an external device (e.g., a paired device), such as neckband 1805. Neckband 1805 generally represents any type or form of paired device. Thus, the following discussion of neckband 1805 may also apply to various other paired devices, such as charging cases, smart watches, smart phones, wrist bands, other wearable devices, hand-held controllers, tablet computers, laptop computers, other external compute devices, etc.

As shown, neckband 1805 may be coupled to eyewear device 1802 via one or more connectors. The connectors may be wired or wireless and may include electrical and/or non-electrical (e.g., structural) components. In some cases, eyewear device 1802 and neckband 1805 may operate independently without any wired or wireless connection between them. While FIG. 18 illustrates the components of eyewear device 1802 and neckband 1805 in example locations on eyewear device 1802 and neckband 1805, the components may be located elsewhere and/or distributed differently on eyewear device 1802 and/or neckband 1805. In some embodiments, the components of eyewear device 1802 and neckband 1805 may be located on one or more additional peripheral devices paired with eyewear device 1802, neckband 1805, or some combination thereof.

Pairing external devices, such as neckband 1805, with augmented-reality eyewear devices may enable the eyewear devices to achieve the form factor of a pair of glasses while still providing sufficient battery and computation power for expanded capabilities. Some or all of the battery power, computational resources, and/or additional features of augmented-reality system 1800 may be provided by a paired device or shared between a paired device and an eyewear device, thus reducing the weight, heat profile, and form factor of the eyewear device overall while still retaining desired functionality. For example, neckband 1805 may allow components that would otherwise be included on an eyewear device to be included in neckband 1805 since users may tolerate a heavier weight load on their shoulders than they would tolerate on their heads. Neckband 1805 may also have a larger surface area over which to diffuse and disperse heat to the ambient environment. Thus, neckband 1805 may allow for greater battery and computation capacity than might otherwise have been possible on a standalone eyewear device. Since weight carried in neckband 1805 may be less invasive to a user than weight carried in eyewear device 1802, a user may tolerate wearing a lighter eyewear device and carrying or wearing the paired device for greater lengths of time than a user would tolerate wearing a heavy standalone eyewear device, thereby enabling users to more fully incorporate artificial-reality environments into their day-to-day activities.

Neckband 1805 may be communicatively coupled with eyewear device 1802 and/or to other devices. These other devices may provide certain functions (e.g., tracking, localizing, depth mapping, processing, storage, etc.) to augmented-reality system 1800. In the embodiment of FIG. 18, neckband 1805 may include two acoustic transducers (e.g., 1820(I) and 1820(J)) that are part of the microphone array (or potentially form their own microphone subarray). Neckband 1805 may also include a controller 1825 and a power source 1835.

Acoustic transducers 1820(I) and 1820(J) of neckband 1805 may be configured to detect sound and convert the detected sound into an electronic format (analog or digital). In the embodiment of FIG. 18, acoustic transducers 1820(I) and 1820(J) may be positioned on neckband 1805, thereby increasing the distance between the neckband acoustic transducers 1820(I) and 1820(J) and other acoustic transducers 1820 positioned on eyewear device 1802. In some cases, increasing the distance between acoustic transducers 1820 of the microphone array may improve the accuracy of beamforming performed via the microphone array. For example, if a sound is detected by acoustic transducers 1820(C) and 1820(D) and the distance between acoustic transducers 1820(C) and 1820(D) is greater than, e.g., the distance between acoustic transducers 1820(D) and 1820(E), the determined source location of the detected sound may be more accurate than if the sound had been detected by acoustic transducers 1820(D) and 1820(E).

Controller 1825 of neckband 1805 may process information generated by the sensors on neckband 1805 and/or augmented-reality system 1800. For example, controller 1825 may process information from the microphone array that describes sounds detected by the microphone array. For each detected sound, controller 1825 may perform a direction-of-arrival (DOA) estimation to estimate a direction from which the detected sound arrived at the microphone array. As the microphone array detects sounds, controller 1825 may populate an audio data set with the information. In embodiments in which augmented-reality system 1800 includes an inertial measurement unit, controller 1825 may compute all inertial and spatial calculations from the IMU located on eyewear device 1802. A connector may convey information between augmented-reality system 1800 and neckband 1805 and between augmented-reality system 1800 and controller 1825. The information may be in the form of optical data, electrical data, wireless data, or any other transmittable data form. Moving the processing of information generated by augmented-reality system 1800 to neckband 1805 may reduce weight and heat in eyewear device 1802, making it more comfortable to the user.

Power source 1835 in neckband 1805 may provide power to eyewear device 1802 and/or to neckband 1805. Power source 1835 may include, without limitation, lithium ion batteries, lithium-polymer batteries, primary lithium batteries, alkaline batteries, or any other form of power storage. In some cases, power source 1835 may be a wired power source. Including power source 1835 on neckband 1805 instead of on eyewear device 1802 may help better distribute the weight and heat generated by power source 1835.

As noted, some artificial-reality systems may, instead of blending an artificial reality with actual reality, substantially replace one or more of a user's sensory perceptions of the real world with a virtual experience. One example of this type of system is a head-worn display system, such as virtual-reality system 1900 in FIG. 19, that mostly or completely covers a user's field of view. Virtual-reality system 1900 may include a front rigid body 1902 and a band 1904 shaped to fit around a user's head. Virtual-reality system 1900 may also include output audio transducers 1906(A) and 1906(B). Furthermore, while not shown in FIG. 19, front rigid body 1902 may include one or more electronic elements, including one or more electronic displays, one or more inertial measurement units (IMUs), one or more tracking emitters or detectors, and/or any other suitable device or system for creating an artificial-reality experience.

Artificial-reality systems may include a variety of types of visual feedback mechanisms. For example, display devices in augmented-reality system 1800 and/or virtual-reality system 1900 may include one or more liquid crystal displays (LCDs), light emitting diode (LED) displays, microLED displays, organic LED (OLED) displays, digital light project (DLP) micro-displays, liquid crystal on silicon (LCoS) micro-displays, and/or any other suitable type of display screen. These artificial-reality systems may include a single display screen for both eyes or may provide a display screen for each eye, which may allow for additional flexibility for varifocal adjustments or for correcting a user's refractive error. Some of these artificial-reality systems may also include optical subsystems having one or more lenses (e.g., conventional concave or convex lenses, Fresnel lenses, adjustable liquid lenses, etc.) through which a user may view a display screen. These optical subsystems may serve a variety of purposes, including to collimate (e.g., make an object appear at a greater distance than its physical distance), to magnify (e.g., make an object appear larger than its actual size), and/or to relay (to, e.g., the viewer's eyes) light. These optical subsystems may be used in a non-pupil-forming architecture (such as a single lens configuration that directly collimates light but results in so-called pincushion distortion) and/or a pupil-forming architecture (such as a multi-lens configuration that produces so-called barrel distortion to nullify pincushion distortion).

In addition to or instead of using display screens, some of the artificial-reality systems described herein may include one or more projection systems. For example, display devices in augmented-reality system 1800 and/or virtual-reality system 1900 may include micro-LED projectors that project light (using, e.g., a waveguide) into display devices, such as clear combiner lenses that allow ambient light to pass through. The display devices may refract the projected light toward a user's pupil and may enable a user to simultaneously view both artificial-reality content and the real world. The display devices may accomplish this using any of a variety of different optical components, including waveguide components (e.g., holographic, planar, diffractive, polarized, and/or reflective waveguide elements), light-manipulation surfaces and elements (such as diffractive, reflective, and refractive elements and gratings), coupling elements, etc. Artificial-reality systems may also be configured with any other suitable type or form of image projection system, such as retinal projectors used in virtual retina displays.

The artificial-reality systems described herein may also include various types of computer vision components and subsystems. For example, augmented-reality system 1800 and/or virtual-reality system 1900 may include one or more optical sensors, such as two-dimensional (2D) or 3D cameras, structured light transmitters and detectors, time-of-flight depth sensors, single-beam or sweeping laser rangefinders, 3D LiDAR sensors, and/or any other suitable type or form of optical sensor. An artificial-reality system may process data from one or more of these sensors to identify a location of a user, to map the real world, to provide a user with context about real-world surroundings, and/or to perform a variety of other functions.

The artificial-reality systems described herein may also include one or more input and/or output audio transducers. Output audio transducers may include voice coil speakers, ribbon speakers, electrostatic speakers, piezoelectric speakers, bone conduction transducers, cartilage conduction transducers, tragus-vibration transducers, and/or any other suitable type or form of audio transducer. Similarly, input audio transducers may include condenser microphones, dynamic microphones, ribbon microphones, and/or any other type or form of input transducer. In some embodiments, a single transducer may be used for both audio input and audio output.

In some embodiments, the artificial-reality systems described herein may also include tactile (i.e., haptic) feedback systems, which may be incorporated into headwear, gloves, body suits, handheld controllers, environmental devices (e.g., chairs, floormats, etc.), and/or any other type of device or system. Haptic feedback systems may provide various types of cutaneous feedback, including vibration, force, traction, texture, and/or temperature. Haptic feedback systems may also provide various types of kinesthetic feedback, such as motion and compliance. Haptic feedback may be implemented using motors, piezoelectric actuators, fluidic systems, and/or a variety of other types of feedback mechanisms. Haptic feedback systems may be implemented independent of other artificial-reality devices, within other artificial-reality devices, and/or in conjunction with other artificial-reality devices.

By providing haptic sensations, audible content, and/or visual content, artificial-reality systems may create an entire virtual experience or enhance a user's real-world experience in a variety of contexts and environments. For instance, artificial-reality systems may assist or extend a user's perception, memory, or cognition within a particular environment. Some systems may enhance a user's interactions with other people in the real world or may enable more immersive interactions with other people in a virtual world. Artificial-reality systems may also be used for educational purposes (e.g., for teaching or training in schools, hospitals, government organizations, military organizations, business enterprises, etc.), entertainment purposes (e.g., for playing video games, listening to music, watching video content, etc.), and/or for accessibility purposes (e.g., as hearing aids, visual aids, etc.). The embodiments disclosed herein may enable or enhance a user's artificial-reality experience in one or more of these contexts and environments and/or in other contexts and environments.

The process parameters and sequence of the steps described and/or illustrated herein are given by way of example only and can be varied as desired. For example, while the steps illustrated and/or described herein may be shown or discussed in a particular order, these steps do not necessarily need to be performed in the order illustrated or discussed. The various exemplary methods described and/or illustrated herein may also omit one or more of the steps described or illustrated herein or include additional steps in addition to those disclosed.

The preceding description has been provided to enable others skilled in the art to best utilize various aspects of the exemplary embodiments disclosed herein. This exemplary description is not intended to be exhaustive or to be limited to any precise form disclosed. Many modifications and variations are possible without departing from the spirit and scope of the present disclosure. The embodiments disclosed herein should be considered in all respects illustrative and not restrictive. Reference should be made to the appended claims and their equivalents in determining the scope of the present disclosure.

Unless otherwise noted, the terms "connected to" and "coupled to" (and their derivatives), as used in the specification and claims, are to be construed as permitting both direct and indirect (i.e., via other elements or components) connection. In addition, the terms "a" or "an," as used in the specification and claims, are to be construed as meaning "at least one of." Finally, for ease of use, the terms "including" and "having" (and their derivatives), as used in the specification and claims, are interchangeable with and have the same meaning as the word "comprising."

As used herein, the term "substantially" in reference to a given parameter, property, or condition may mean and include to a degree that one of ordinary skill in the art would understand that the given parameter, property, or condition is met with a small degree of variance, such as within acceptable manufacturing tolerances. By way of example, depending on the particular parameter, property, or condition that is substantially met, the parameter, property, or condition may be at least approximately 90% met, at least approximately 95% met, or even at least approximately 99% met.

As used herein, the term "approximately" in reference to a particular numeric value or range of values may, in certain embodiments, mean and include the stated value as well as all values within 10% of the stated value. Thus, by way of example, reference to the numeric value "50" as "approximately 50" may, in certain embodiments, include values equal to 50±5, i.e., values within the range 45 to 55.

It will be understood that when an element such as a layer or a region is referred to as being formed on, deposited on, or disposed "on" or "over" another element, it may be located directly on at least a portion of the other element, or one or more intervening elements may also be present. In contrast, when an element is referred to as being "directly on" or "directly over" another element, it may be located on at least a portion of the other element, with no intervening elements present.

While various features, elements or steps of particular embodiments may be disclosed using the transitional phrase "comprising," it is to be understood that alternative embodiments, including those that may be described using the transitional phrases "consisting" or "consisting essentially of," are implied. Thus, for example, implied alternative embodiments to a polymer thin film that comprises or includes polyvinylidene fluoride include embodiments where a polymer thin film consists essentially of polyvinylidene fluoride and embodiments where a polymer thin film consists of polyvinylidene fluoride.

**Claims**

1. A polymer article, comprising:

    a crystalline fluoropolymer; and
    a nucleating agent, wherein the polymer article has an elastic modulus of at least approximately 3 GPa and an electromechanical coupling factor ($k_{31}$) of at least approximately 0.15.

2. The polymer article of claim 1, wherein the polymer article comprises a thin film or a fiber.

3. The polymer article of claim 1 or 2, wherein the crystalline fluoropolymer comprises a monomodal molecular weight distribution or a bimodal molecular weight distribution.

4. The polymer article of any preceding claim, wherein the crystalline fluoropolymer comprises a moiety selected from the group consisting of vinylidene fluoride, trifluoroethylene, chlorotrifluoroethylene, hexafluoropropylene, vinyl fluoride, homopolymers thereof, co-polymers thereof, and tri-polymers thereof.

5. The polymer article of any preceding claim, wherein the nucleating agent comprises less than approximately 10 wt.% of the polymer article; preferably wherein the nucleating agent comprises tetrabutylammonium hydrogen sulfate, 1-N,3-N,5-N-tris(3-methylbutan-2-yl)benzene-1,3,5-tricarboxamide, or 1,3,5-triaminobenzene: N-[3,5-bis(2,2-dimethylpropanoylamino)phenyl]-2,2-dimethylpropanamide.

6. The polymer article of any preceding claim, wherein the polymer article is optically clear and comprises less than approximately 10% bulk haze.

7. The polymer article of any preceding claim, wherein the polymer article comprises a color coordinate ($|b*|$) of less than approximately 10 for a thickness of less than approximately 300 micrometers.

8. The polymer article of any preceding claim, wherein the polymer article comprises a piezoelectric strain coefficient $d_{31}$ of at least approximately 10 pC/N.

9. The polymer article of any preceding claim, wherein the polymer article further comprises an inorganic additive.

10. The polymer article of any preceding claim, wherein the polymer article has bulk haze of less than approximately 3% over a thickness of approximately 40 micrometers.

11. The polymer article of any preceding claim, wherein the polymer article has a transmissivity of at least approximately 80% across the visible spectrum.

12. A method comprising:

combining a crystallizable fluoropolymer and a nucleating agent to form a mixture; and forming the mixture into a polymer article, wherein the polymer article has an elastic modulus of at least approximately 3 GPa and an electromechanical coupling factor ($k_{31}$) of at least approximately 0.15.

13. The method of claim 12, wherein forming the mixture into a polymer article comprises extruding the mixture or forming the mixture into a solution or a gel and casting the solution or the gel.

14. The method of claim 12 or 13, further comprising one, any two, or each of:

applying a stress to the polymer article in an amount sufficient to re-orient crystals or align polymer chains within the polymer article; applying an electric field to the polymer article; and annealing the polymer article.

15. The method of any of claims 12 to 14, wherein the polymer article comprises a fiber and the method further comprises forming the fiber into a thin film using a process selected from the group consisting of weaving, knitting, and cross-linking.

Melt Process:

| PVDF Melt | → | Extrusion | → | Stretching | → | Poling | → | PVDF film |

Solvent Process:

| PVDF Solution | → | Casting | → | Solvent Removal | → | Stretching | → | Poling | → | PVDF film |

**FIG. 1**

EP 4 335 896 A1

FIG. 2

FIG. 3

**FIG. 4**

## Partial Positive Surface Charge Nucleating Agents

tetrabutylammonium hydrogen sulfate
Mp: 174 °C

triphenylheptylphosphonium bromide
Mp: 178 °C

N-methyl-N-butylpyrrolidinium bromide
Mp: 204 °C

tetrabutylammonium perchlorate
Mp: 211 °C

tetrabutylammonium hexafluorophosphate
Mp: 250 °C

N-methyl-N-butylpyrrolidinium chloride
Mp: 191 °C

N-methyl-N-butylpyrrolidinium iodide
Mp: 184 °C

tetrabutylphosphonium hexafluorophosphate
Mp: 217 °C

tetrabutyl-n-phosphonium tetraphenylborate
Mp: 230 °C

ethyltriphenylphosphonium bromide
Mp: 206 °C

(4-carboxybutyl)triphenylphosphonium bromide
Mp: 205 °C

(2-carboxyethyl)triphenylphosphonium bromide
Mp: 195 °C

(5-carboxypentyl)triphenylphosphonium bromide
Mp: 202 °C

(3-phenylpropyl)triphenylphosphonium bromide
Mp: 209 °C

N-phenacylpyridinium bromide
Mp: 198 °C

N-acetonylpyridinium bromide
Mp: 184 °C

2-methyl-1-(2-oxo-propyl)-pyridinium bromide
Mp: 202 °C

(2-thienylacetyl)pyridinium bromide
Mp: 200 °C

N-(2-furoylmethyl)pyridinium bromide
Mp: 208 °C

1-(2-oxo-2-(4-(trifluoromethyl)phenyl)ethyl)
pyridin-1-ium bromide
Mp: 219 °C

## FIG. 5

EP 4 335 896 A1

| | | | | | | |
|---|---|---|---|---|---|---|
| Tetraproylammonium Hydrogen Sulfate | Tetraproylammonium Tetrafluoroborate | Tetraproylammonium Hexylflurophosphate | Tetraproylammonium Fluoride | Tetraproylammonium Chloride | Tetraproylammonium Bromide | Tetraproylammonium iodide |
| Mp (°C): 161 | - | - | - | 240-242 | 270 | 280-285 |

| | | | | |
|---|---|---|---|---|
| Tetrabutylammonium tetrafluoroborate | Tetrabutylammonium fluoride | Tetrabutylammonium chloride | Tetrabutylammonium bromide | Tetrabutylammonium iodide |
| Mp (°C): 162 | 62-63 | 47-50°C | 102-106 | 141-143 |

| | | | | | | |
|---|---|---|---|---|---|---|
| Tetrahexylammonium hydrogen sulfate | Tetrahexylammonium tetrafluoroborate | Tetrahexylammonium hexylfluorophosphate | Tetrahexylammonium fluoride | Tetrahexylammonium chloride | Tetrahexylammonium bromide | Tetrahexylammonium iodide |
| Mp (°C): 98-100 | 90-92 | 135-138 | - | 111-113 | 99-100 | 99-101 |

*FIG. 5*
*(Continued)*

EP 4 335 896 A1

Diisopropylammonium   Diisopropylammonium   Diisopropylammonium
Chloride                          Bromide                              Iodide

Mp (°C):              -                        246-248                      -

Tris(Tetrabutylammonium)          Tris-(tributylammonium)
Hydrogen Pyrophosphate                pyrophosphate

-                                              -

Tetraproylammonium        Tetraproylammonium        Cetyltrimethylammonium        Cetyltrimethylammonium
Hydrogen Sulfate              Hydrogen sulfate               Hydrogen sulfate                     Bromide

Mp (°C):      >260                      240                            250-260                          248-251

*FIG. 5*
*(Continued)*

Partial Negative Surface Charge Nucleating Agents

Sodium Dodecyl-sulfate
Mp: 198°C

Sodium Tetradecyl Sulphate
Mp: 205°C

1-Naphthylphosphate, Monosodium Salt
Mp: 186°C

Sodium;1,3,7,9-Tetratert-Butyl-11-Oxide-5H-Benzo[d][1,3,2]Benzodioxaphosphocine 11-Oxide

Potassium;1,3,7,9-Tetratert-Butyl-11-Oxide-5H-Benzo[d][1,3,2]Benzodioxaphosphocine 11-Oxide

Disodium;Bicyclo[2.2.1]Heptane-2,3-Dicarboxylate

FIG. 6

26

Charge Neutral Nucleating Agents

flavanthrone
Mp: > 300 °C

N,N'-bis[2-(2-aminoethyl)octadecanoyl] decanediamide

N,N'-dicyclohexyl-2,6-naphthalenedicarboxamide
Mp: 300 °C

N-methyl toluene sulfonamide

| R | Mp |
|---|---|
| | sublimed |
| | 289 °C |
| | sublimed |
| | sublimed |
| | 263 °C |
| | 371 °C |
| | 315 °C |
| | 312 °C |

*FIG. 7*

(1R)-1-[(4R,4aR,8aS)-2,6-bis(3,4-Dimethylphenyl)-4,4a,8,8a-Tetrahydro-[1,3]Dioxino[5,4-d][1,3]Dioxin-4-yl]Ethane-1,2-diol

1-[8-Propyl-2,6-bis(4-Propylphenyl)-4,4a,8,8a-Tetrahydro-[1,3]Dioxino[5,4-d][1,3]Dioxin-4-yl]Ethane-1,2-diol

## FIG. 7
## (Continued)

EP 4 335 896 A1

FIG. 8

EP 4 335 896 A1

EP 4 335 896 A1

Bond to Nitrogen is Drawn to the Left

1,3,5-Benzene-Tricarboxamide

R:

1,3,5-tris((2-Ethyl-Aziridinyl)-Carbonyl)

1-N,3-N,5-N-tris[2-(Tert-butylamino)-2-Oxoethyl]-1-
N,3-N,5-N-Tricyclohexylbenzene-1,3,5-Tricarboxamide

**FIG. 9**

Bond to Amide is Drawn to the Left

1,3,5-Triaminobenzene

R:

Mp (°C):     Sublimated        286

**FIG. 10**

Bond to Amide is Drawn to the Left

1,3,5-Triaminobenzene

2,4,6-Tris(Pivaloylamino)Phenol

N-[3-(2,2-Dimethylpropanoylamino)-5-Nitrophenyl]-2,2-Dimethylpropanamide

3,5-bis[(2,2-Dimethylpropanoyl)Amino]-N-Phenylbenzamide

FIG. 11

EP 4 335 896 A1

FIG. 12

*FIG. 13*

1400

1420

1405

1415

1410

**FIG. 14**

**FIG. 15**

**FIG. 16**

| Nucleating Agent Loading | Transmission % | Haze % (Surface + Bulk) | Haze % Bulk Only | Film Thickness μm | Bulk Haze % Per 40 μm Thickness | Absolute Beta Crystallinity % | Modulus GPa | Yellowness B* per 100 μm Thickness | $d_{33}$ pC/N | $d_{31}$ pC/N | $k_{31}$ |
|---|---|---|---|---|---|---|---|---|---|---|---|
| 0% | 88 | 61.1 | 50.1 | 54 | 37.11 | 63 | 4.7 | 0.45 | | | |
| 0.05% | 88 | 48.5 | 1.85 | 48 | 1.54 | 63 | 4.2 | 0.55 | | | |
| 0.1% | 88 | 30.2 | 1.08 | 51 | 0.85 | 61 | 4.5 | 0.57 | | | |
| 0.25% | 92 | 2.2 | 0.11 | 56 | 0.08 | 62 | 4.4 | 0.52 | 14.2 | 19.1 | 0.12 |
| 0.5% | 92 | 3.1 | 0.56 | 47 | 0.48 | 66 | 4.5 | 0.82 | 27.5 | 14.8 | 0.09 |
| Comparative PVDF | Not Transparent or Not Optical Grade | | | | | 30-40 | ~2.5 | | | | |

*FIG. 17*

**FIG. 18**

EP 4 335 896 A1

System
1900

1904

1902

1906(A)

1906(B)

**FIG. 19**

Europäisches
Patentamt

European
Patent Office

Office européen
des brevets

# EUROPEAN SEARCH REPORT

Application Number

EP 23 19 2776

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2022/254989 A1 (OUDERKIRK ANDREW JOHN [US] ET AL) 11 August 2022 (2022-08-11) * paragraphs [0013], [0057], [0090] – [0109] * * claims * | 1-15 | INV. C08K3/30 C08K5/00 C08K5/19 C08K5/20 C08L27/16 H10N30/857 |
| Y | BAUR CARY ET AL: "Enhanced piezoelectric performance from carbon fluoropolymer nanocomposites", JOURNAL OF APPLIED PHYSICS, AMERICAN INSTITUTE OF PHYSICS, 2 HUNTINGTON QUADRANGLE, MELVILLE, NY 11747, vol. 112, no. 12, 15 December 2012 (2012-12-15), pages 124104-124104, XP012167350, ISSN: 0021-8979, DOI: 10.1063/1.4768923 [retrieved on 2012-12-17] * page 2 * * page 3, left-hand column * * page 3, right-hand column, lines 2-12 * * "Mechanical characteristics"; page 5; figure 7 * * page 6, left-hand column * | 1-15 | |
| Y | WO 2013/003758 A2 (SAINT GOBAIN PERFORMANCE PLAST [US]; UNIV MASSACHUSETTS [US]) 3 January 2013 (2013-01-03) * page 1, lines 21-22 * * examples * | 1-15 | TECHNICAL FIELDS SEARCHED (IPC) C09J C08J C08K C08L H02N H10N |

The present search report has been drawn up for all claims

| Place of search | Date of completion of the search | Examiner |
|---|---|---|
| Munich | 31 January 2024 | Behm, Sonja |

EPO FORM 1503 03.82 (P04C01)

## ANNEX TO THE EUROPEAN SEARCH REPORT
## ON EUROPEAN PATENT APPLICATION NO.

EP 23 19 2776

This annex lists the patent family members relating to the patent documents cited in the above-mentioned European search report.
The members are as contained in the European Patent Office EDP file on
The European Patent Office is in no way liable for these particulars which are merely given for the purpose of information.

31-01-2024

| Patent document cited in search report | Publication date | Patent family member(s) | | Publication date |
|---|---|---|---|---|
| US 2022254989 A1 | 11-08-2022 | NONE | | |
| WO 2013003758 A2 | 03-01-2013 | CN | 103748175 A | 23-04-2014 |
| | | EP | 2726553 A2 | 07-05-2014 |
| | | JP | 2014518326 A | 28-07-2014 |
| | | KR | 20140033206 A | 17-03-2014 |
| | | US | 2013005878 A1 | 03-01-2013 |
| | | WO | 2013003758 A2 | 03-01-2013 |

EPO FORM P0459

For more details about this annex : see Official Journal of the European Patent Office, No. 12/82